# FASCICULE DE BREVET EUROPEEN

(11) **EP 3 895 216 B1**
(45) Date de publication et mention de la délivrance du brevet: **11.10.2023**
(21) Numéro de dépôt: 19839351.4
(22) Date de dépôt: 03.12.2019
(51) Int. Cl.: H01L 27/15, H01L 33/12

(54) **DISPOSITIF OPTOÉLECTRONIQUE COMPORTANT DES PIXELS ÉMETTANT TROIS COULEURS**
OPTOELEKTRONISCHE VORRICHTUNG MIT PIXELN, DIE DREI FARBEN EMITTIEREN
OPTOELECTRONIC DEVICE COMPRISING PIXELS EMITTING THREE COLOURS

(30) Priorité: 11.12.2018 FR 1872710
(43) Date de publication de la demande: 20.10.2021
(73) Titulaire: Aledia, 38130 Echirolles (FR)
(72) Inventeur: ROBIN, Ivan-Christophe, 38000 Grenoble (FR)
(74) Mandataire: Germain Maureau
(86) Numéro de dépôt international: PCT/FR2019/052904
(87) Numéro de publication internationale: WO 2020/120875

(56) Documents cités:
- WO-A1-2017/062889
- FR-A1- 3 019 380
- US-A1- 2009 078 955
- US-A1- 2013 134 388
- US-A1- 2018 269 352
- MITCHELL BRANDON ET AL: "Perspective: Toward efficient GaN-based red light emitting diodes using europium doping", JOURNAL OF APPLIED PHYSICS, AMERICAN INSTITUTE OF PHYSICS, US, vol. 123, no. 16, 29 mars 2018 (2018-03-29), XP012227404, ISSN: 0021-8979, DOI: 10.1063/1.5010762 [extrait le 2018-03-29]

## Description

### DOMAINE TECHNIQUE

L'invention concerne un dispositif optoélectronique tel que défini par la revendication 1.

La présente invention concerne également un procédé de fabrication d'un tel dispositif optoélectronique.

L'invention trouve une application notamment dans les écrans d'affichage ou les systèmes de projection d'images.

### ETAT DE LA TECHNIQUE ANTERIEURE

Par « dispositif optoélectronique », il est entendu dans ce document un dispositif adapté à effectuer la conversion d'un signal électrique en un rayonnement électromagnétique à émettre, notamment de la lumière.

Il existe des dispositifs optoélectroniques comportant des diodes électroluminescentes, également connues sous l'acronyme « LED » pour « light-emitting diode » selon la terminologie anglo-saxonne consacrée, formées sur un substrat.

Il est connu que chaque diode électroluminescente comprenne une couche active exploitant des puits quantiques, une portion semiconductrice dopée selon un premier type de dopage pour jouer le rôle de jonction dopée N et une portion semiconductrice dopée selon un deuxième type de dopage pour jouer le rôle de jonction dopée P.

Chaque diode électroluminescente peut être formée sur la base d'éléments semiconducteurs, par exemple obtenus au moins partiellement par épitaxie. Les diodes électroluminescentes sont typiquement formées à base d'un matériau semiconducteur comprenant des éléments de la colonne III et de la colonne V du tableau périodique, tel qu'un composé III-V, notamment le nitrure de gallium (GaN), le nitrure d'indium et de gallium (InGaN) ou le nitrure d'aluminium et de gallium (AIGaN).

Afin de former une image, le dispositif optoélectronique peut être organisé en pixels indépendants.

Il existe notamment des dispositifs optoélectroniques comportant une matrice de diodes électroluminescentes présentant une certaine surface d'émission au travers de laquelle est transmis les rayonnements lumineux émis par les diodes électroluminescentes. De tels dispositifs optoélectroniques peuvent notamment être utilisés dans la constitution d'écrans d'affichage ou de systèmes de projection d'images, où la matrice de diodes électroluminescentes définit une matrice de pixels lumineux où chaque pixel comporte une ou plusieurs diodes électroluminescentes. Notamment, chaque pixel comprend classiquement :
- au moins un sous-pixel formé d'au moins une diode électroluminescente apte à générer directement, ou à transmettre par l'intermédiaire d'un convertisseur de lumière adapté, de la lumière bleue,
- au moins un sous-pixel formé d'au moins une diode électroluminescente apte à générer directement, ou à transmettre par l'intermédiaire d'un convertisseur de lumière adapté, de la lumière verte,
- au moins un sous-pixel formé d'au moins une diode électroluminescente apte à générer directement, ou à transmettre par l'intermédiaire d'un convertisseur de lumière adapté, de la lumière rouge.

L'une des difficultés est de parvenir à ce que chaque pixel puisse émettre des lumières de différentes couleurs, par exemples bleues, vertes et rouges et ce à partir de matériaux de type GaN, InGaN ou AIGaN qui ne requièrent pas de changement de technique de formation d'un sous-pixel à l'autre et d'un pixel à l'autre.

Une première solution connue prévoit que chaque pixel comprenne au moins une diode électroluminescente apte à émettre de la lumière bleue, au moins une diode électroluminescente apte à émettre de la lumière verte et au moins une diode électroluminescente apte à émettre de la lumière rouge. Pour y parvenir, les diodes électroluminescentes qui sont aptes à émettre une lumière dans une couleur donnée sont fabriquées sur un même substrat, cela étant répété séparément pour les trois couleurs. Puis chaque substrat est découpé afin de délimiter des dispositifs individuels. Chaque pixel est alors obtenu par reconstruction afin d'associer de tels dispositifs individuels de manière à disposer des trois couleurs.

Cette solution, également connue sous le nom de « pick and place » selon la terminologie anglo-saxonne consacrée, n'est pas optimale car elle engendre de nombreuses manipulations, un temps de fabrication et des coûts élevés, ainsi qu'un nombre de connexions important. Compte tenu de la miniaturisation toujours croissante, cette solution peut même parfois s'avérer malheureusement impossible à mettre en oeuvre.

D'autre part, généralement la couleur rouge est obtenue à partir du matériau de formule « InGaAlP » mais cette technique présente des inconvénients tels que le fait de présenter une variation importante de la longueur d'onde en fonction de la température, le fait de varier d'efficacité en fonction de la taille des diodes électroluminescentes (l'efficacité diminuant pour des micro diodes inférieures à 30 microns) et le fait que la croissance de ce matériau est délicate.

Un autre inconvénient de cette dernière technique est qu'elle implique la présence d'une couche d'isolant électronique intercalaire (souvent du SiOz) dans l'assemblage des couches. Ceci impose que la formation des reprises de contacts électriques est complexe et peut générer des capacités parasites.

Une autre solution consiste à prévoir que les diodes électroluminescentes soient adaptées à émettre une lumière dans les couleurs bleues. Afin que le pixel lumineux puisse émettre dans les couleurs vertes et/ou dans les couleurs rouges, ce dernier peut comporter des plots photoluminescents jouant le rôle de convertisseur de couleur au niveau de certains sous-pixels : chaque plot photoluminescent est conçu de sorte à absorber au moins une partie de la lumière bleue émise par les diodes électroluminescentes et à la convertir en une lumière verte ou rouge. Ces plots photoluminescents sont habituellement formés d'une matrice liante adaptée.

Toutefois, cette solution ne donne pas une entière satisfaction car les plots photoluminescents induisent des pertes lumineuses élevées. Généralement, le taux de conversion des plots est en effet compris entre 50% et 80%. De plus, elle reste complexe et assez coûteuse à mettre en oeuvre en raison des opérations dédiées à la fabrication des plots photoluminescents.

Les documents FR 3 019 380 A1, US 2018/269352 A1 et US 2009/078955 A1 divulguent une autre solution, selon laquelle des sous-pixels de différentes couleurs sont crûs de manière monolithique. En particulier, deux structures DELs destinées à émettre des couleurs différentes sont formées l'une au-dessus de l'autre, puis sélectivement gravées pour définir des sous-pixels de couleurs différentes.

### EXPOSE DE L'INVENTION

La présente invention vise à résoudre tout ou partie des inconvénients présentés ci-avant.

Dans ce contexte, un objectif est donc de fournir une solution répondant aux objectifs suivants :
- disposer d'une architecture monolithique permettant de générer au moins deux couleurs, voire trois couleurs, dans un même pixel sans manipulation mécanique,
- proposer une fabrication simple et économique,
- avoir un rendement lumineux élevé,
- incorporer des quantités élevées d'indium, notamment dans une proportion supérieure à 20%, dans des puits quantiques d'InGaN sans dégrader l'efficacité des puits quantiques, notamment pour s'affranchir du recours à de l'InGaAIP,
- obtenir un arrangement de couches sans isolant électronique intercalaire.

Ce but peut être atteint grâce à la mise en oeuvre d'un dispositif optoélectronique selon la revendication 1.

L'invention porte également sur un procédé de fabrication d'un dispositif tel que défini par la revendication 16.

### BREVE DESCRIPTION DES DESSINS

D'autres aspects, buts, avantages et caractéristiques de l'invention apparaîtront mieux à la lecture de la description détaillée suivante de modes de réalisation préférés de celle-ci, donnée à titre d'exemple non limitatif, et faite en référence aux dessins annexés sur lesquels :
La figure 1 est une vue schématique en coupe d'un exemple de réalisation d'un empilement de couches pouvant être utilisé dans les figures suivantes.
La figure 2 est une vue schématique en coupe, au niveau d'un sous-pixel, d'un exemple de réalisation d'un dispositif optoélectronique selon l'invention.
La figure 3 est une vue schématique en coupe, au niveau d'un sous-pixel, d'un autre exemple de réalisation d'un dispositif optoélectronique selon l'invention.
La figure 4 est une vue schématique en coupe, au niveau d'un sous-pixel, d'un autre exemple de réalisation d'un dispositif optoélectronique selon l'invention.
La figure 5 est une vue schématique en coupe, au niveau de trois sous-pixels, d'une première étape d'un premier exemple de procédé de fabrication d'un dispositif optoélectronique selon l'invention.
La figure 6 est une vue schématique en coupe, au niveau de trois sous-pixels, d'une première étape d'un second exemple de procédé de fabrication d'un dispositif optoélectronique selon l'invention.
La figure 7 est une vue schématique en coupe, au niveau de trois sous-pixels, d'une deuxième étape du second exemple de procédé de fabrication d'un dispositif optoélectronique selon l'invention.
La figure 8 est une vue schématique en coupe, au niveau de trois sous-pixels, d'une deuxième étape du premier exemple de procédé de fabrication d'un dispositif optoélectronique selon l'invention.
La figure 9 est une vue schématique en coupe, au niveau de trois sous-pixels, d'une troisième étape du second exemple de procédé de fabrication d'un dispositif optoélectronique selon l'invention.
La figure 10 est une vue schématique en coupe, au niveau de trois sous-pixels, d'une troisième étape du premier exemple de procédé de fabrication d'un dispositif optoélectronique selon l'invention.

### EXPOSE DETAILLE DE MODES DE REALISATION PARTICULIERS

Sur les figures et dans la suite de la description, les éléments identiques ou similaires sont repérés par des références identiques, pour simplifier la lecture et la compréhension. De plus, les différents éléments ne sont pas représentés à l'échelle de manière à privilégier la clarté des figures. Par ailleurs, les différents modes de réalisation et variantes ne sont pas exclusifs les uns des autres et peuvent être combinés entre eux.

Dans la suite de la description, sauf indication contraire, les termes "sensiblement", "environ" et "de l'ordre de" signifient "à 10 % près".

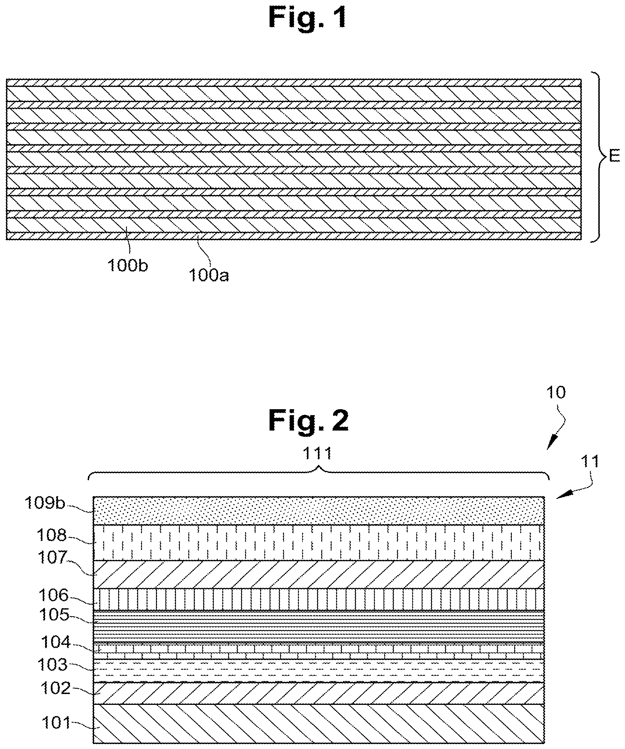

La figure 1 représente un exemple de réalisation d'un empilement de couches minces décrites ci-après, cet empilement étant noté « E » et pouvant servir à la constitution d'un premier empilement primaire 103a, d'un deuxième empilement primaire 105a ou d'un troisième empilement primaire 107a détaillés plus loin. Alternativement ou de manière combinée, l'empilement E peut être utilisé pour la constitution d'un premier empilement secondaire 103, d'un deuxième empilement secondaire 105 ou d'un troisième empilement secondaire 107 détaillés plus loin et/ou pour la constitution d'un premier empilement tertiaire 103b ou d'un deuxième empilement tertiaire 105b.

A l'image de l'empilement E schématisé sur la figure 1, chacun des empilements primaires 103a, 105a, 107a, des empilements secondaires 103, 105, 107 et des empilements tertiaires 103b, 105b comporte au moins deux couches principales notées « 100b » formées en nitrure d'indium et de gallium, ce matériau étant de formule « InGaN ». Ces deux couches 100b sont séparées deux à deux au moins par une couche intermédiaire notée « 100a » formée en nitrure de gallium, de formule « GaN ». Dans l'empilement E, au moins l'une des couches principales 100b est dopée selon un premier type de dopage choisi parmi un dopage de type N et un dopage de type P. Le mode de réalisation illustré sur la figure 1, qui met en oeuvre sept couches principales 100b et six couches intermédiaires 100a, voire en plus deux couches supplémentaires respectivement supérieure et inférieure identiques aux couches intermédiaires 100a, est toutefois non limitatif et illustré uniquement à titre d'exemple pour faciliter la compréhension de l'invention. En effet, le nombre des couches 100a et 100b peut être variable en fonction des besoins. Pour être efficaces, les empilements primaires 103a, 105a, 107a, les empilements secondaires 103, 105, 107 ou les empilements tertiaires 103b, 105b peuvent contenir au minimum deux couches principales 100b et une couche intermédiaire 100a. Mais chacun des empilements susmentionnés peut comprendre par exemple jusqu'à environ cinquante couches principales 100b et environ cinquante couches intermédiaires 100a. Les proportions en Indium peuvent varier d'une couche principale à une autre.

Chacun des empilements primaires 103a, 105a, 107a est notamment configuré de sorte à pouvoir servir de base à la fabrication ultérieure de couches actives primaires 104a, 106a d'un sous-pixel primaire 112 d'un dispositif optoélectronique 10. De manière complémentaire, chacun des empilements secondaires 103, 105, 107 est notamment configuré de sorte à pouvoir servir de base à la fabrication ultérieure de couches actives secondaires 104, 106, 108 d'un sous-pixel secondaire 111 du dispositif optoélectronique 10. En complément ou en substitution, les empilements tertiaires 103b, 105b peuvent notamment être configurés de sorte à pouvoir servir de base à la fabrication ultérieure de couches actives tertiaires 104b d'un sous-pixel tertiaire 113 du dispositif optoélectronique 10. Etant intercalés entre les couches actives, les empilements primaires, secondaires et tertiaires permettent avantageusement de pouvoir obtenir des couches actives de concentration en Indium différentes au sein d'un même sous-pixel et ce par relaxation progressive des contraintes.

L'invention trouvera une application notamment dans la fabrication d'écrans d'affichage ou de systèmes de projection d'images sur la base d'un tel dispositif optoélectronique 10.

Une couche principale 100b peut contenir une proportion d'indium selon la formule In_{w}Ga_{1-w}N où w est supérieur ou égal à 0 et inférieur à 1. Cependant, dans la pratique, si la couche d'In_{w}Ga_{1-w}N a des proportions d'indium dépassant 25%, pour des épaisseurs importantes et si la couche sur laquelle est obtenue ladite couche active contient une proportion d'indium très différente de la proportion d'indium contenue dans la couche active, cela pourrait éventuellement engendrer des défauts structuraux pénalisants. Pour pallier à cela, les empilements primaires 103a, 105a, 107a, les empilements secondaires 103, 105, 107 ou les empilements tertiaires 103b, 105b peuvent optionnellement alterner plusieurs couches principales 100b de faibles épaisseurs entre 0,5 nm et 15 nm et plusieurs couches intermédiaires 100a de faibles épaisseurs 0,5 nm et 15 nm. Cela permet avantageusement d'obtenir des proportions d'indium pouvant atteindre 50% et de permettre de limiter les désaccords de maille. Un premier empilement primaire 103a, ou un premier empilement secondaire 103 ou un premier empilement tertiaire 103b peut ainsi avantageusement contenir une proportion d'indium telle que des couches actives primaires 104a ou des couches actives secondaires 104 ou des couches actives tertiaires 104b obtenues sur ces premiers empilements 103a, 103, 103b peuvent par exemple contenir une proportion d'indium permettant de générer une couleur sensiblement rouge ou verte ou bleue.

A titre d'exemple, chaque couche principale 100b d'InGaN présente une épaisseur comprise entre 5 nm et 9 nm et chaque couche intermédiaire 100a de GaN présente une épaisseur comprise 0,5 nm et 1 nm.

Selon l'invention, les premiers empilements primaires 103a, les premiers empilements secondaires 103 ou les premiers empilements tertiaires 103b contiennent une proportion d'indium telle que In_{z}Ga_{1-z}N où z est supérieur ou égal à 0 et est inférieur à 0,1. Ainsi, les couches actives primaires 104a ou les couches actives secondaires 104 ou les couches actives tertiaires 104b formées sur ces premiers empilements primaires 103a, ces premiers empilements secondaires 103 ou ces premiers empilements tertiaires 103b, respectivement, peuvent par exemple contenir une proportion d'indium permettant de générer une couleur sensiblement bleue.

Selon l'invention, les deuxièmes empilements primaires 105a, les deuxièmes empilements secondaires 105 ou les deuxièmes empilements tertiaires 105b contiennent une proportion d'indium telle que InₓGa₁₋ₓN où x est supérieur ou égal à 0,1 et est inférieur à 0,2. Ainsi, les couches actives primaires 106a et les couches actives secondaires 106 formées respectivement sur ces deuxièmes empilements primaires 105a ou sur ces deuxièmes empilements secondaires 105 peuvent par exemple contenir une proportion d'indium permettant de générer une couleur sensiblement verte.

Avantageusement, les troisièmes empilements primaires 107a ou les troisièmes empilements secondaires 107 contiennent une proportion d'indium telle que In_{y}Ga_{1-y}N où y est supérieur ou égal à 0,2 et est inférieur à 0,35. Ainsi, les couches actives primaires 108 formées sur les troisièmes empilements secondaires 107 peuvent par exemple contenir une proportion d'indium permettant de générer une couleur sensiblement rouge.

Dans un exemple, la concentration en Indium de la première couche active secondaire 104 est supérieure ou égale à la concentration en Indium d'au moins l'une des premières couches principales 100b du premier empilement secondaire 103.

Dans un autre exemple, la concentration en Indium de la deuxième couche active secondaire 106 est supérieure ou égale à la concentration en Indium d'au moins l'une des deuxièmes couches principales 100b du deuxième empilement secondaire 105.

Dans un autre exemple, la concentration en Indium de la troisième couche active secondaire 108 est supérieure ou égale à la concentration en Indium d'au moins l'une des troisièmes couches principales 100b du troisième empilement secondaire 107.

Les couches principales 100b et/ou les couches intermédiaires 100a peuvent être dopées selon un premier type de dopage (typiquement un dopage de type P pour jouer le rôle de partie dopée P d'une jonction P-N ou un dopage de type N pour jouer le rôle de partie dopée N d'une jonction P-N) ou selon un deuxième type de dopage (opposé au premier type de dopage décrit ci-avant : il s'agit d'un dopage de type P si le premier type de dopage est un dopage N, ou d'un dopage de type N si le premier type de dopage est un dopage P).

A titre d'exemple, le dopant peut être choisi parmi le groupe comprenant un dopant de type P du groupe II, par exemple, du Magnésium, du zinc, du cadmium, ou du mercure, un dopant de type P du groupe IV par exemple du carbone ou un dopant de type N du groupe IV par exemple du silicium, du germanium, du sélénium, du souffre, du terbium ou de l'étain.

Avantageusement, au sein d'un même sous-pixel donné, la formation d'un troisième empilement 107 formé sur un deuxième empilement 105, 105a lui-même formé sur un premier empilement 103, 103a, 103b pour fabriquer ce sous-pixel, permet de générer la couleur rouge, sans utiliser le matériau de formule InGaAIP, par adaptation progressive de paramètres de maille et par diminution des contraintes. Cela permet d'utiliser également un même procédé de fabrication pour obtenir trois couleurs différentes en trois sous-pixels différents obtenus en même temps et par des mêmes techniques sur un même substrat, permettant de limiter considérablement le nombre de manipulation, le temps de fabrication, le nombre de connexions et/ou le nombre de tests. Cela permet également de s'affranchir de la nécessité de recourir à des convertisseurs de couleurs, facilitant encore la fabrication et permettant d'atteindre de très bons rendements lumineux.

Dans ce document, la notion de « primaire » fait uniquement référence à un premier sous-pixel d'un pixel donné, ce premier sous-pixel étant destiné à émettre une lumière selon une première couleur. La notion de « secondaire » fait uniquement référence à un deuxième sous-pixel du pixel, ce deuxième sous-pixel étant destiné à émettre une lumière selon une deuxième couleur différente de la première couleur. La notion de « tertiaire » fait uniquement référence à un troisième sous-pixel du pixel, ce troisième sous-pixel étant destiné à émettre une lumière selon une troisième couleur différente de la première couleur et de la deuxième couleur. Autrement dit, les termes « primaire », « secondaire » et « tertiaire » n'induisent aucune notion d'ordre de fabrication ou d'ordre d'importance entre les différents sous-pixels.

D'autre part, le dispositif optoélectronique 10 selon l'invention, qui peut comprendre une pluralité de pixels où chaque pixel comprend différents sous-pixels capables d'émettre à des lumières différentes et où chaque sous-pixel comprend lui-même une ou plusieurs diodes électroluminescentes, est tel qu'un pixel donné comprend au moins un sous-pixel primaire 112 tel que détaillé plus loin et illustré sur les figures, et en plus au moins un sous-pixel secondaire 111 tel que détaillé plus loin et illustré sur les figures et/ou au moins un sous-pixel tertiaire 113 tel que détaillé plus loin et illustré sur les figures. Autrement dit, en plus d'au moins un sous-pixel primaire 112, le pixel comprend:
- un sous-pixel tertiaire 113 indépendamment de la présence ou non d'un sous-pixel secondaire 111,
- un sous-pixel secondaire 111 indépendamment de la présence ou non d'un sous-pixel tertiaire 113.

La figure 2 illustre un mode de réalisation d'un sous-pixel secondaire 111. Le sous-pixel secondaire 111 est formé par la superposition, sur un substrat 101, d'au moins un empilement secondaire 103, d'une couche active secondaire 104, d'au moins un deuxième empilement secondaire 105, d'au moins une deuxième couche active secondaire 106, d'au moins un troisième empilement secondaire 107, d'au moins une troisième couche active secondaire 108 et d'au moins une première couche de jonction secondaire 109b dopée selon un deuxième type de dopage avantageusement P. Par « formé », il est entendu que l'empilement secondaire 103 peut être formé directement sur la face supérieure 110 du substrat 101 ou peut être formé indirectement sur celle-ci avec interposition au moins d'une couche tampon 102 semiconductrice formée sur la face support 101.

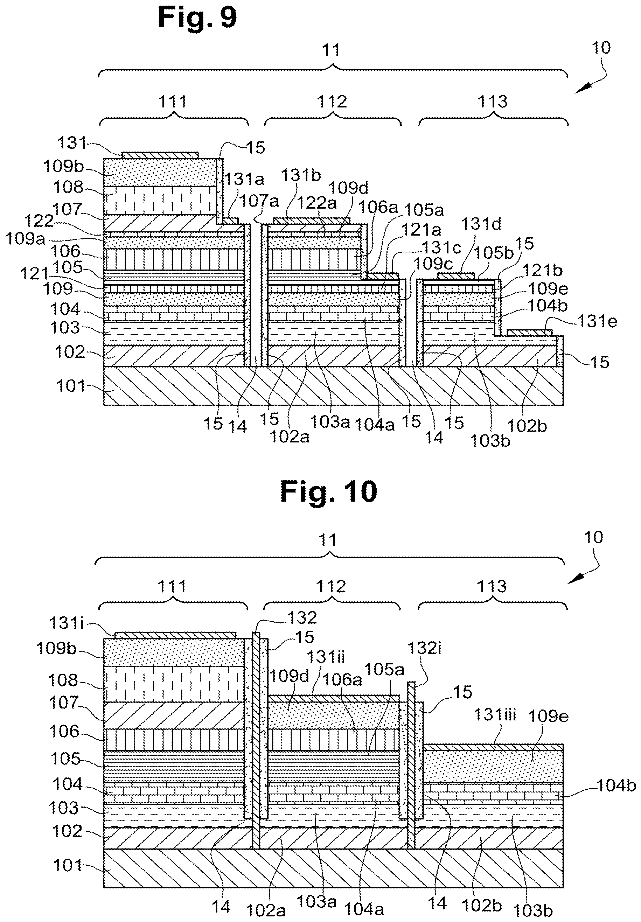

Comme montré sur la figure 10, en réalisant des premiers contacts électriques secondaires 131, 131i connectés électriquement avec la première couche de jonction secondaire 109b, et des seconds contacts électriques secondaires 131a, 132 connectés électriquement avec au moins un troisième empilement secondaire 107, il est possible d'obtenir, par une stimulation électrique appropriée, une émission de lumière d'un deuxième rayonnement lumineux préférentiellement rouge depuis la troisième couche active secondaire 108. Typiquement, la deuxième longueur d'onde du deuxième rayonnement lumineux apte à être émis par la troisième couche active secondaire 108 est comprise entre 590 et 700 nm de sorte que le deuxième rayonnement lumineux est sensiblement de couleur rouge.

Par « connecté électriquement », il est entendu que des électrons ou des trous peuvent passer depuis les contacts électriques jusqu'à atteindre les couches concernées et ceci à travers une ou plusieurs couches. Autrement dit, les électrons étant beaucoup plus mobiles que les trous, lorsqu'une différence de potentiels positive est appliquée entre la première couche de jonction secondaire 109b et la couche tampon 102 semiconductrice, les trous circulant de la première couche de jonction secondaire 109b vers la couche tampon 102 semiconductrice restent dans la troisième couche active secondaire 108 alors que les électrons circulant de la première couche de jonction secondaire 109b vers la couche tampon 102 semiconductrice peuvent traverser les couches ou empilements 103, 104, 105, 106 et 107 pour se recombiner avec les trous dans la couche active secondaire 108. Les recombinaisons ont lieu dans la zone active la plus proche de la couche p. Ainsi, il n'y a pas exactement le même potentiel électrique entre la couche tampon 102 semiconductrice et le troisième empilement secondaire 107. Il en est de même pour le sous-pixel 112.

Dans un exemple, au moins un des contacts électriques choisi parmi les seconds contacts électriques tertiaires 131e, 132i et les seconds contacts électriques secondaires 132 est en contact électrique direct avec au moins un élément choisi parmi les couches tampon 102, 102a, 102b semiconductrices et les premiers empilements 103a, 103, 103b. Par « contact électrique direct », il est entendu ici que l'élément conducteur faisant contact électrique est agencé sur et en contact mécanique avec l'élément à contacter électriquement.

Le substrat 101 peut être transparent au rayonnement lumineux concerné, par exemple être en un matériau isolant ou semiconducteur comme par exemple de l'Al₂O₃ ou du saphir ou du ZnO. L'étape de formation du susbtrat n'est pas limitative en soi et il peut être envisagé de mettre en oeuvre toute technique connue à cet effet.

Par « transparent », il est entendu que le substrat 101 est tel qu'il peut être traversé avec un absorption nulle ou faible par des rayons lumineux du domaine visible et/ou de l'ultraviolet. Il peut également être prévu la formation d'une couche de nucléation (non représentée) apte à favoriser la croissance de couches semiconductrices, par exemple de GaN, entre le substrat 101 et la couche tampon 102 semiconductrice proprement dite.

Dans un exemple, le substrat 101 est transparent au premier rayonnement lumineux et/ou au deuxième rayonnement lumineux et/ou au troisième rayonnement lumineux.

Le substrat 101 peut contenir des parties conductrices (non représentées) aptes à constituer des électrodes pour les sous-pixels.

Le substrat 101 peut être obtenu en formant un substrat non-transparent, par exemple en silicium ou en GaAs, et par exemple en le gravant en tout ou partie ou en le retirant au moyen, par exemple, d'une étape intermédiaire de collage.

La couche tampon 102 semiconductrice, est telle qu'elle permet l'adaptation des paramètres de maille et la relaxation des contraintes entre le substrat 101 et les premiers empilements secondaires 103, les premiers empilements tertiaires 103b ou les premiers empilements primaires 103a ou les premières couches actives 104, 104a, 104b. Elle peut être composée de nitrure de gallium de plusieurs microns d'épaisseur. Alternativement, elle peut être composée d'une alternance de couches de nitrure de gallium et de nitrure d'aluminium. De façon générale, les couches tampon semiconductrices, repérées 102a, 102, 102b respectivement pour les sous-pixels primaires 112, les sous-pixels secondaires 111 et les sou-pixels tertiaires 113, peuvent être issues d'une seule couche continue déposée initialement sur tout ou partie du substrat 101 puis mise en forme ultérieurement.

Selon un exemple, la première couche active secondaire 104 peut comporter des moyens de confinement des porteurs de charge électrique, tels que des puits quantiques unitaires ou multiples. Elle est par exemple constituée d'une alternance de couches de GaN et de InGaN ayant des épaisseurs respectives de 5 à 20 nm (par exemple 8 nm) et de 1 à 15 nm (par exemple 2,5 nm). Les couches de GaN peuvent être dopées, par exemple de type N ou P. Selon un autre exemple, la couche active peut comprendre une seule couche d'InGaN, par exemple d'épaisseur supérieure à 10 nm. Préférentiellement, la proportion d'indium dans la première couche active secondaire 104 est supérieure à la proportion d'indium dans le premier empilement secondaire 103. Dans un exemple, la proportion d'indium dans les couches principales des premiers empilements primaires, secondaires et tertiaires 103a, 103, 103b est comprise entre 0 et 10 % (ce qui peut se traduire par l'expression In_{z}Ga_{1-z}N où 0≤z<0,1). La proportion d'indium dans les puits quantiques de la première couche active secondaire 104 peut alors être supérieure ou égale à 10 %, préférentiellement entre 15% et 25%.

Selon un exemple, la deuxième couche active secondaire 106 peut comporter des moyens de confinement des porteurs de charge électrique, tels que des puits quantiques multiples. Elle est par exemple constituée d'une alternance de couches de GaN et de InGaN ayant des épaisseurs respectives de 5 à 20 nm (par exemple 8 nm) et de 1 à 15 nm (par exemple 2,5 nm). Les couches de GaN peuvent être dopées, par exemple de type N ou P. Selon un autre exemple, la deuxième couche active secondaire 106 peut comprendre une seule couche d'InGaN, par exemple d'épaisseur supérieure à 10 nm.

Préférentiellement, la proportion d'indium dans la deuxième couche active secondaire 106 est supérieure à la proportion d'indium dans le deuxième empilement secondaire 105.

Dans un exemple, la proportion d'indium dans les couches principales 100b du deuxième empilement secondaire 105 est comprise entre 10 et 20 % (ce qui peut se traduire par l'expression InₓGa₁₋ₓN où 0,1≤z<0,2). La proportion d'indium dans les puits quantiques de la deuxième couche active 106 peut alors être supérieure ou égale à 22%, préférentiellement entre 22% et 35%.

La troisième couche active secondaire 108 est la couche depuis laquelle est émise une partie du rayonnement rouge fourni par le pixel. Selon un exemple, la troisième couche active secondaire 108 peut comporter des moyens de confinement des porteurs de charge électrique, tels que des puits quantiques multiples. Elle est par exemple constituée d'une alternance de couches de GaN et de InGaN ayant des épaisseurs respectives de 5 à 20 nm (par exemple 8 nm) et de 1 à 15 nm (par exemple 2,5 nm). Les couches de GaN peuvent être dopées, par exemple de type N ou P. Selon un autre exemple, la troisième couche active secondaire 108 peut comprendre une seule couche d'InGaN, par exemple ayant une épaisseur supérieure à 10 nm.

Préférentiellement, la proportion d'indium dans la troisième couche active secondaire 108 est supérieure ou égale à la proportion d'indium dans le troisième empilement secondaire 107.

Dans un exemple, la proportion d'indium dans les couches principales 100b du troisième empilement secondaire 107 est comprise entre 20 et 35 % (ce qui peut se traduire par l'expression In_{y}Ga_{1-y}N avec 0,2≤y≤0,35). La proportion d'indium dans les puits quantiques de la troisième couche active secondaire 108 peut alors être supérieure ou égale à 30 %, préférentiellement comprise entre 30% et 50% pour obtenir une émission de lumière rouge.

La première couche de jonction secondaire 109b est une couche semiconductrice, composée par exemple de GaN, d'InGaN ou d'un empilement de plusieurs de ces deux matériaux. Cette couche peut être dopée selon un dopage P si le premier type de dopage du premier empilement est dopé N ou dopée N si le premier type de dopage du premier empilement est de type P. La première couche de jonction secondaire 109b permet de former la seconde partie dopée d'une jonction P-N ou P-IN.

Avantageusement, la première couche de jonction secondaire 109b est composée de GaN dopé selon un dopage P car, associé à des couches d'InGaN, cela permet de ne pas utiliser de couche d'isolant intercalaire.

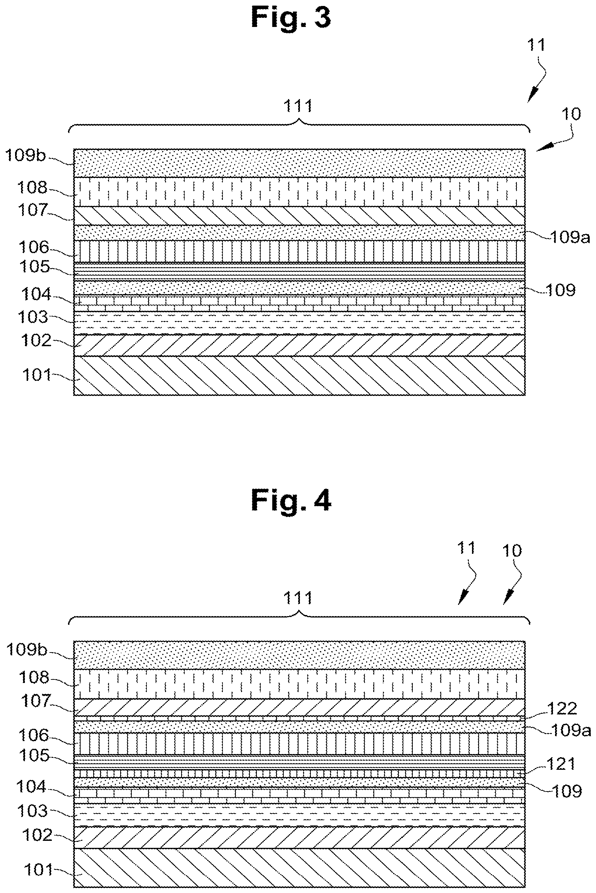

Les figures 3 et 4 illustrent un autre mode de réalisation d'un sous-pixel secondaire 111. Le sous-pixel secondaire 111 est formé par la superposition, sur un substrat 101, d'une couche tampon 102 semiconductrice obtenue sur tout ou partie de la face support 110 du substrat 101, d'au moins un premier empilement secondaire 103, d'au moins une première couche active secondaire 104, d'au moins un deuxième empilement secondaire 105, d'au moins une deuxième couche active secondaire 106, d'au moins un troisième empilement secondaire 107, d'au moins une troisième couche active secondaire 108 et d'au moins une première couche de jonction secondaire 109b dopée selon un deuxième type de dopage avantageusement P. Le sous-pixel secondaire 111 comprend également une deuxième couche de jonction secondaire 109 formée en tout ou partie sur tout ou partie de la première couche active secondaire 104 et dopée selon le deuxième type de dopage, d'autre part une première jonction tunnel secondaire 121 formée entre tout ou partie du deuxième empilement secondaire 105 et tout ou partie de la deuxième couche de jonction secondaire 109. Le sous-pixel secondaire 111 comprend également une troisième couche de jonction secondaire 109a formée en tout ou partie sur tout ou partie de la deuxième couche active secondaire 106 et dopée selon le deuxième type de dopage. Le sous-pixel secondaire 111 comprend également de façon facultative mais préférée une deuxième jonction tunnel secondaire 122 formée entre tout ou partie du troisième empilement secondaire 107 et tout ou partie de la troisième couche de jonction secondaire 109a.

Les jonctions tunnels 121, 122 sont implémentées pour répondre à la problématique de la reprise de contact électrique sur une couche mince de GaN dopé P (notée « P-GaN ») rendue accessible au préalable par gravure plasma. En effet, les ions énergétiques utilisés pour la gravure plasma induisent des défauts dans la couche de P-GaN. Les jonctions tunnels sont obtenues en créant une première zone fortement dopée P (notée « P++-GaN ») et une deuxième zone fortement dopée N (notée « N++-GaN ») obtenue sur la couche P++-GaN. Les trous sont ainsi injectés dans la couche P++-GaN par effet tunnel des électrons entre la bande de valence de la couche P++-GaN et la bande de conduction de la couche N++-GaN. Ainsi, il est possible de reprendre un contact électrique sur une couche dopéee N++-GaN plutôt que sur une couche dopée P-GaN ayant subie une gravure plasma.

Les deuxièmes et troisièmes couches secondaires de jonction peuvent être dopées P si le premier type de dopage du premier empilement secondaire 103 est dopé N ou dopées N si le premier type de dopage du premier empilement secondaire 103 est de type P.

Avantageusement, les premières, deuxièmes et troisièmes couches de jonction secondaires 109b, 109, 109a sont composées de GaN dopé P car cela permet de ne pas utiliser de couche d'isolant intercalaire. Un autre avantage est que cela permet d'empiler plusieurs jonctions P-N.

De façon générale, les différentes couches composant les sous-pixels primaires, secondaires ou tertiaires 112, 111, 113 respectivement, peuvent être obtenues par exemple par épitaxie en utilisant des jets moléculaires (technique connue sous l'acronyme « MBE » pour « Molecular Beam Epitaxy » selon l'expression anglo-saxonne consacrée) ou bien par dépôt métallo-organique chimique en phase vapeur (technique connue sous l'acronyme « MOCVD » pour « Metal Organic Chemical Vapor Déposition » selon l'expression anglo-saxonne consacrée) ou toute autre technique connue et adaptée.

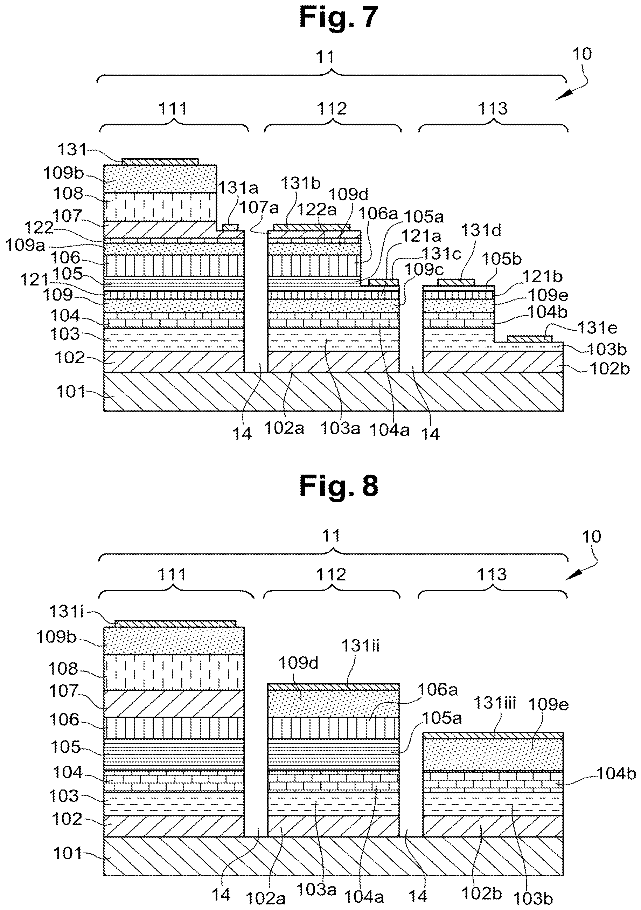

Comme illustré sur les figures 7, 9 et 10, des premiers contacts électriques secondaires 131, 131i peuvent être formés et connectés électriquement avec la première couche de jonction secondaire 109b et des seconds contacts électriques secondaires 131a, 132 peuvent être formés et connectés électriquement avec ledit au moins un troisième empilement secondaire 107. Avantageusement, les premiers contacts électriques secondaires 131, 131i sont isolés électriquement par rapport aux seconds contacts électriques secondaires 131a, 132. Par exemple, une couche d'isolant électrique 15 peut les séparer. Il est également possible, dans un autre exemple qui peut être combiné au précédent, de former des tranchées isolantes 14 électriquement sensiblement transversales à la surface support 110.

En appliquant une tension entre les premiers contacts électriques secondaires 131 et les seconds contacts électriques secondaires 131a, il est ainsi obtenu l'émission de lumière préférentiellement rouge depuis la troisième couche active secondaire 108.

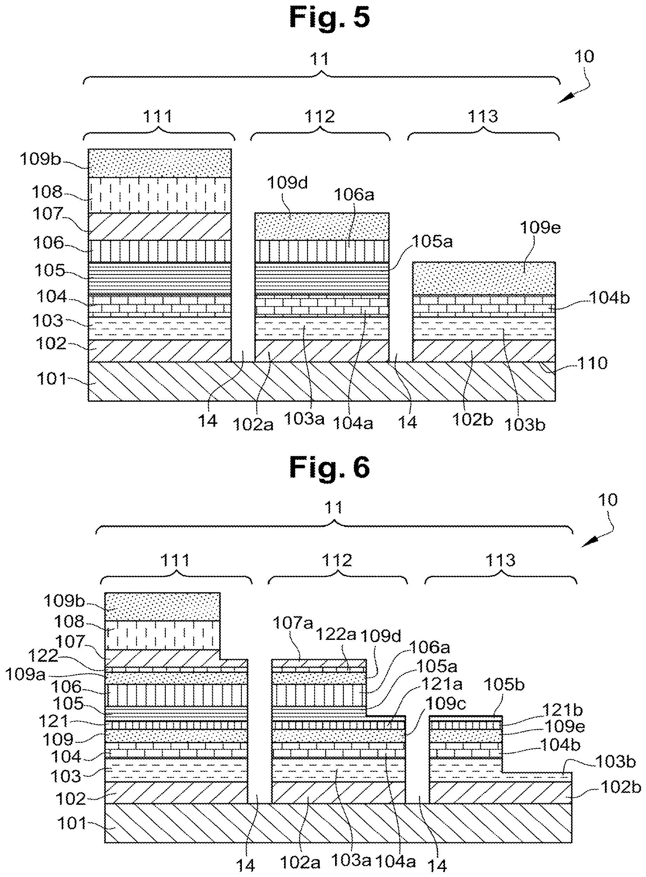

Dans un mode de réalisation d'un dispositif selon l'invention illustré sur les figures 5, 8 et 10, un sous-pixel primaire 112 est formé par au moins un premier empilement primaire 103a comportant au moins deux premières couches principales 100b de nitrure d'indium et de gallium répondant à la formule In_{z}Ga_{1-z}N où z est supérieur ou égal à 0 et est inférieur à 0,1, les premières couches principales 100b étant séparées deux à deux au moins par une première couche intermédiaire 100a de nitrure de gallium. Au moins l'une des premières couches principales 100b peut être dopée selon un premier type de dopage choisi parmi un dopage de type N et un dopage de type P. Tout ou partie du premier empilement primaire 103a est formé sur tout ou partie de la couche tampon 102a semiconductrice facultative formée préalablement sur la surface support 110. Au moins une première couche active primaire 104a est formée en tout ou partie sur tout ou partie du premier empilement primaire 103a. La première couche active primaire 104a peut comporter au moins un puits quantique. Au moins un deuxième empilement primaire 105a est formé en tout ou partie sur tout ou partie de la première couche active primaire 104a. L'empilement primaire 105a comporte au moins deux deuxièmes couches principales de nitrure d'indium et de gallium répondant à la formule InₓGa₁₋ₓN où x est supérieur ou égal à 0,1 et est inférieur à 0,2, les deuxièmes couches principales 100b étant séparées deux à deux au moins par une deuxième couche intermédiaire 100a de nitrure de gallium, au moins l'une des deuxièmes couches principales 100b étant dopée selon le premier type de dopage choisi parmi un dopage de type N et un dopage de type P. Au moins une deuxième couche active primaire 106a est formée en tout ou partie sur tout ou partie du deuxième empilement primaire 105a et elle comporte au moins un deuxième puits quantique. Une première couche de jonction primaire 109d est formée sur la deuxième couche active primaire 106a de sorte à être en contact avec celle-ci. La première couche de jonction primaire 109d est dopée selon un deuxième type de dopage choisi parmi un dopage de type N et un dopage de type P, le deuxième type de dopage étant différent du premier type de dopage, de sorte que la deuxième couche active primaire 106a puisse émettre un premier rayonnement lumineux sensiblement vert.

La première couche de jonction primaire 109d est une couche semiconductrice composée par exemple de GaN, d'InGaN ou d'un empilement de plusieurs de ces deux matériaux.

La couche tampon 102a semiconductrice est telle qu'elle permet l'adaptation des paramètres de maille et la relaxation des contraintes entre le substrat 101 et le premier empilement primaire 103a ou la première couche active primaire 104a. Elle peut être composée de GaN de plusieurs microns d'épaisseur. Alternativement, elle peut être composée d'une alternance de couches de GaN, d'AIN ou encore d'AlGaN.

Selon un exemple, la première couche active primaire 104a peut comporter des moyens de confinement des porteurs de charge électrique, tels que des puits quantiques multiples. Elle est par exemple constituée d'une alternance de couches de GaN et de InGaN ayant des épaisseurs respectives de 5 à 20 nm (par exemple 8 nm) et de 1 à 15 nm (par exemple 2,5 nm). Les couches de GaN peuvent être dopées, par exemple de type N ou P. Selon un autre exemple, la couche active 104a peut comprendre une seule couche d'InGaN, par exemple d'épaisseur supérieure à 10 nm. Préférentiellement, la proportion d'indium dans la première couche active primaire 104a est supérieure ou égale à la proportion d'indium dans le premier empilement primaire 103a. Dans un exemple, la proportion d'indium dans les couches principales 100b des premiers empilements primaires 103a est comprise entre 0 et 10 % (ce qui peut se traduire par l'expression In_{z}Ga_{1-z}N où 0≤z<0,1). La proportion d'indium dans les puits quantiques de la première couche active primaire 104a peut alors être supérieure ou égale à 10%, préférentiellement entre 15% et 22%.

Selon un exemple, la deuxième couche active primaire 106a peut comporter des moyens de confinement des porteurs de charge électrique, tels que des puits quantiques multiples. Elle est par exemple constituée d'une alternance de couches de GaN et de InGaN ayant des épaisseurs respectives de 5 à 20 nm (par exemple 8 nm) et de 1 à 15 nm (par exemple 2,5 nm). Les couches de GaN peuvent être dopées, par exemple de type N ou P. Selon un autre exemple, la deuxième couche active primaire 106a peut comprendre une seule couche d'InGaN, par exemple d'épaisseur supérieure à 10 nm.

Préférentiellement, la proportion d'indium dans la deuxième couche active primaire 106a est supérieure ou égale à la proportion d'indium dans le deuxième empilement primaire 105a.

Dans un exemple, la proportion d'indium dans les couches principales 100b du deuxième empilement primaire 105a est comprise entre 10 et 20 % (ce qui peut se traduire par l'expression InₓGa₁₋ₓN où 0,1≤x<0,2). La proportion d'indium dans les puits quantiques de la deuxième couche active primaire 106a peut alors être supérieure ou égale à 25 %, préférentiellement entre 25% et 35%.

Des premiers contacts électriques primaires 131b, 131ii peuvent être formés pour être connectés électriquement avec la première couche de jonction primaire 109d et des seconds contacts électriques primaires 131c, 132i pour être connectés électriquement avec le deuxième empilement primaire 105a d'un sous-pixel primaire 112. Les seconds contacts électriques primaires 131c, 132i peuvent être formés directement en contact avec le substrat 101.

Avantageusement, les premiers contacts électriques primaires 131b, 131ii sont isolés électriquement par rapport aux seconds contacts électriques secondaires 131a, 132. Par exemple, une couche d'isolant électrique 15 peut les séparer. Il est également possible, dans un autre exemple qui peut être combiné au précédent, de former des tranchées isolantes 14 sensiblement transversales à la surface support 110.

Avantageusement, afin de créer au moins une électrode commune à au moins deux sous-pixels 111, 112, 113 au niveau du substrat 101, un matériau isolant électrique 15 est formé dans tout ou partie du volume libre d'au moins une tranchée isolante 14 obtenue précédemment. Une électrode commune à au moins deux sous-pixel 111, 112, 113 est réalisée en formant au moins un des contacts électriques 132, 132i sur tout ou partie de la face support 110 du substrat 101 et/ou à travers tout ou partie du matériau isolant électrique 15 obtenu précédemment. Le substrat 101 peut déjà contenir, à sa formation, des électrodes prédéfinies. Les contacts électriques 132, 132i peuvent alors être connectés lors de leur formation directement à ces électrodes prédéfinies (non représentées). Les contacts électriques 132, 132i peuvent également avantageusement être connectés électriquement aux premiers empilements 103, 103a, 103b et/ou aux couches tampon 102, 102a, 102b semiconductrices. Avantageusement, cette architecture permet d'avoir une électrode commune à au moins deux sous-pixels.

En appliquant une tension entre les premiers contacts électriques primaires 131ii et les seconds contacts électriques primaires 132i, il peut être obtenu l'émission de lumière préférentiellement selon une deuxième longueur d'onde sensiblement verte depuis la deuxième couche active primaire 106a. La première longueur d'onde du premier rayonnement lumineux apte à être émis par la deuxième couche active primaire 106a est comprise entre 500 nm et 550 nm de sorte que le deuxième rayonnement lumineux est sensiblement de couleur verte.

Dans un autre mode de réalisation selon l'invention d'un sous-pixel primaire 112 illustré sur les figures 6, 7 et 9, une deuxième couche de jonction primaire 109c dopée selon le deuxième type de dopage (préférentiellement un dopage de type P) est formée en tout ou partie sur tout ou partie de la première couche active primaire 104a. La deuxième couche de jonction primaire 109c est une couche semiconductrice composée par exemple de GaN, d'InGaN ou d'un empilement de plusieurs de ces deux matériaux.

D'autre part, une première jonction tunnel primaire 121a est formée entre tout ou partie du deuxième empilement primaire 105a et tout ou partie de la deuxième couche de jonction primaire 109c.

Facultativement, une deuxième jonction tunnel primaire 122a peut être formée entre tout ou partie du deuxième empilement primaire 106a et tout ou partie de la deuxième couche de jonction primaire 109d.

Les jonctions tunnels 121a, 122a sont implémentées pour répondre à la problématique de la reprise de contact électrique sur une couche mince de GaN dopé P (notée « P-GaN ») rendue accessible au préalable par gravure plasma. En effet, les ions énergétiques utilisés pour la gravure plasma induisent des défauts dans la couche de P-GaN. Les jonctions tunnels sont obtenues en créant une première zone fortement dopée P (notée « P++-GaN ») et une deuxième zone fortement dopée N (notée « N++-GaN ») obtenue sur la couche P++-GaN. Les trous sont ainsi injectés dans la couche P++-GaN par effet tunnel des électrons entre la bande de valence de la couche P++-GaN et la bande de conduction de la couche N++-GaN. Ainsi, il est possible de reprendre un contact électrique sur une couche dopéee N++-GaN plutôt que sur une couche dopée P-GaN ayant subie une gravure plasma.

Des premiers contacts électriques primaires 131b, 131ii sont formés sur tout ou partie du troisième empilement primaire 107a. Des seconds contacts électriques primaires 131c, 132i peuvent également être formés en contact avec le deuxième empilement primaire 105a. Pour atteindre le deuxième empilement primaire 105a avant de former les seconds contacts électriques primaires 131c, 132i, il est possible de réaliser une gravure à travers les différentes couches.

Dans un autre mode de réalisation selon l'invention illustré sur les figures 5, 8 et 10, au moins un sous-pixel tertiaire 113 est formé sur la surface support 110 du substrat 101 en étant décalé d'au moins un sous-pixel primaire 112 dans un plan général orienté parallèlement au plan de la face support 110 du substrat 101. Le sous-pixel tertiaire 113 est formé par la superposition des éléments décrits ci-après. Une couche tampon 102b semiconductrice facultative est formée sur tout ou partie du substrat 101. Un premier empilement tertiaire 103b comportant au moins deux premières couches principales 100b de nitrure d'indium et de gallium répondant à la formule In_{z}Ga_{1-z}N où z est supérieur ou égale à 0 et est inférieur à 0,1, est formé sur tout ou partie de la couche tampon 102b semiconductrice. Les premières couches principales 100b sont séparées deux à deux au moins par une première couche intermédiaire de nitrure de gallium, au moins l'une des premières couches principales 100b étant dopée selon un premier type de dopage choisi parmi un dopage de type N et un dopage de type P. Au moins une couche active tertiaire 104b est formée en tout ou partie sur tout ou partie du premier empilement tertiaire 103b. Ladite au moins une couche active tertiaire 104b comporte au moins un puits quantique. Au moins une couche de jonction tertiaire 109e est formée sur la couche active tertiaire 104b en étant en contact avec celle-ci. La couche de jonction tertiaire 109e est une couche semiconductrice composée par exemple de GaN, d'InGaN ou d'un empilement de plusieurs de ces deux matériaux. La couche de jonction tertiaire 109e est dopée selon un deuxième type de dopage choisi parmi un dopage de type N et un dopage de type P, le deuxième type de dopage étant différent du premier type de dopage, de sorte que la couche active tertiaire 104b soit apte à émettre ledit troisième rayonnement lumineux.

Avantageusement, la concentration en Indium de la première couche active tertiaire 104b est supérieure ou égale à la concentration en Indium d'au moins l'une des premières couches principales 100b du premier empilement tertiaire 103b. La proportion d'indium dans les puits quantiques de la première couche active primaire 104a peut alors être supérieure ou égale à 10 %, préférentiellement entre 15% et 22%.

La troisième longueur d'onde du troisième rayonnement lumineux émis par la couche active tertiaire 104b est comprise entre 430 nm et 490 nm de sorte que le troisième rayonnement lumineux est sensiblement de couleur bleue.

Des premiers contacts électriques tertiaires 131d, 131iii peuvent être formés sur la couche de jonction tertiaire 109e pour connecter électriquement la couche de jonction tertiaire 109e. Des seconds contacts électriques tertiaires 131e, 132i sont connectés électriquement avec le premier empilement tertiaire 103b. Avantageusement, au moins un sous-pixel tertiaire 113 est isolé électriquement par rapport à un autre sous-pixel tertiaire 113 ou par rapport au sous-pixel secondaire 111 ou par rapport au sous-pixel primaire 112 par une tranchée isolante 14, ladite tranchée isolante 14 étant orientée transversalement par rapport au plan général orienté parallèlement au plan de la face support 110 du substrat 101. Avantageusement, afin de créer au moins une électrode commune à au moins deux sous-pixels 111, 112, 113 au niveau du substrat 101, un matériau isolant électrique 15 est formé dans tout ou partie du volume libre d'au moins une tranchée 14 obtenue précédemment. Une électrode commune à au moins deux sous-pixel 111, 112, 113 est réalisée en formant au moins un contact électrique 132, 132i sur tout ou partie de la face support 110 du substrat 101 et/ou à travers tout ou partie du matériau isolant électrique 15 obtenu précédemment. Le substrat 101 peut déjà contenir, à sa formation, des électrodes prédéfinies. Les contacts électriques 132, 132i peuvent alors être connectés lors de leur formation directement à ces électrodes prédéfinies (non représentées).

Dans un autre mode de réalisation selon l'invention illustré sur les figures 6, 7 et 9, au moins un sous-pixel tertiaire 113 comprend au moins un deuxième empilement tertiaire 105b formé en tout ou partie sur tout ou partie de la couche de jonction tertiaire 109e et comportant au moins deux deuxièmes couches principales 100b de nitrure d'indium et de gallium répondant à la formule InₓGa₁₋ₓN où x est supérieur ou égal à 0,1 et est inférieur à 0,2. Les deuxièmes couches principales 100b sont séparées deux à deux au moins par une deuxième couche intermédiaire 100a de nitrure de gallium, au moins l'une des deuxièmes couches principales 100b étant dopée selon le premier type de dopage choisi parmi un dopage de type N et un dopage de type P. Au moins une jonction tunnel tertiaire 121b est formée entre tout ou partie du deuxième empilement tertiaire 105b et tout ou partie de la couche de jonction tertiaire 109e.

Avantageusement, la jonction tunnel 121b est implémentée pour répondre à la problématique de la reprise de contact électrique sur la couche de jonction tertiaire 109e rendue accessible au préalable par gravure plasma.

Des premiers contacts électriques tertiaires 131d, 131iii peuvent être formés sur le deuxième empilement tertiaire 105b. Les seconds contacts électriques tertiaires 131e, 132i sont connectés électriquement avec le premier empilement tertiaire 103b. A cet effet, une gravure débouchant sur le premier empilement tertiaire 103b permet de découvrir le premier empilement tertiaire 103b pour pouvoir y former directement un contact électrique.

Les contacts électriques primaires, secondaires ou tertiaires 131i, 131ii, 131b, 131, 131c, 132, 132i, 131e, 131iii sont faits de préférence : d'une couche métallique, par exemple en aluminium, en cuivre, en or, en ruthénium ou en argent, ou d'un empilement de couches métalliques, par exemple en titane-aluminium, en silicium-aluminium, en titane-nickel-argent, en cuivre ou en zinc. A titre d'exemple, les contacts électriques primaires, secondaires ou tertiaires 131i, 131ii, 131b, 131, 131c, 132i, 132 ont une épaisseur comprise entre 5 nm et 5000 nm, de préférence entre 400 nm et 800 nm. Ils peuvent également avoir un rôle de réflecteur pour renvoyer dans la direction du substrat 101 les rayons émis en provenance des zones actives primaires 106a ou secondaires 108 ou tertiaires 104b.

A l'exception des contacts électriques, les différentes couches composant les sous-pixels primaires 112, les sous-pixels secondaires 111 et les sous-pixels tertiaires 113 peuvent être avantageusement aptes à laisser passer tout ou partie d'au moins un rayonnement électromagnétique de longueur d'onde comprise entre 350 nm et 800 nm. En effet, il est intéressant de prévoir que le deuxième rayonnement de lumière rouge émis par la troisième couche active secondaire 108 d'un sous-pixel secondaire 111 et le premier rayonnement de lumière verte émis par la deuxième couche active 106a d'un sous-pixel primaire 112 et le troisième rayonnement lumineux issu des sous-pixels 113 puissent avantageusement sortir à travers le substrat 101.

Avantageusement, tout ou partie d'au moins un sous-pixel primaire 112 est formé dans le même temps que tout ou partie d'au moins un premier sous-pixel secondaire 111 et/ou dans le même temps que tout ou partie d'au moins un premier sous-pixel tertiaire 113. Autrement dit, tout ou partie de la phase de formation du sous-pixel primaire 112 est mise en oeuvre durant tout ou partie de la phase de formation du sous-pixel secondaire 111 et/ou durant tout ou partie de la phase de formation du sous-pixel tertiaire 113.

Plus précisément, au moins l'une des conditions suivantes est vérifiée :
- les premiers empilements 103, 103a, 103b de deux sous-pixels distincts sont formés en même temps et avec une même technique,
- les deuxièmes empilements 105, 105a, 105b de deux sous-pixels distincts sont formés en même temps et avec une même technique,
- les premières couches actives 104, 104a, 104b de deux sous-pixels distincts sont formés en même temps et avec une même technique,
- les deuxièmes couches actives 106, 106a de deux sous-pixels distincts sont formés en même temps et avec une même technique,
- les couches de jonction 109, 109e, 109c de deux sous-pixels distincts sont formés en même temps et avec une même technique,
- les troisièmes empilements 107a, 107 de deux sous-pixels distincts sont formés en même temps et avec une même technique,
- les premières jonctions tunnels 121, 121a, 121b de deux sous-pixels distincts sont formés en même temps et avec une même technique,
- les deuxièmes jonctions tunnels 122, 122a de deux sous-pixels distincts sont formés en même temps et avec une même technique.

De telles configurations permettent avantageusement, de part la forme avantageuse de la structure des bandes de conduction et de valence et des profils de potentiels obtenus, d'obtenir une émission de lumière uniquement rouge depuis un sous-pixel secondaire 111, ainsi qu'une émission de lumière uniquement verte depuis un sous-pixel primaire 112, ainsi qu'une émission de lumière uniquement bleue depuis un sous-pixel tertiaire 113.

Avantageusement, ces architectures permettent de s'affranchir de la présence d'une couche d'isolant intercalaire car il n'y a pas d'action de collage. En effet, l'utilisation de plusieurs empilements comme décrits précédemment permet d'utiliser une architecture monolithique faite de matériaux similaires (InGaN/GaN) dans toutes les étapes des différentes phases de formation des différents sous-pixels contrairement à l'utilisation d'un semiconducteur différent comme l'InGaAIP. Cela permet également d'obtenir un bon rendement, une bonne productivité de fabrication du fait que les dépôts se font dans la même machine et potentiellement sans manipulation mécanique.

Préférentiellement, les couches similaires comme les premiers empilements 103, 103a, 103b, ou les seconds empilements 105, 105a, 105b, ou les premières couches actives 104, 104a, 104b, ou les deuxièmes couches actives 106, 106a, ou les couches de jonctions 109, 109e, 109c ou les troisièmes empilements 107, 107a ou encore les premières jonctions tunnels 121, 121b, 121a ou les deuxièmes jonctions tunnels 122, 122a, sont formées en même temps et avec la même technique.

Dans un mode de réalisation dont les étapes sont illustrées sur les figures 2, 5, 8 et 10, une étape illustrée sur la figure 2 consiste à obtenir un empilement, sur un substrat 101, d'une couche tampon 102 semiconductrice, d'un premier empilement secondaire 103, d'une première couche active secondaire 104, d'un deuxième empilement secondaire 105, d'une deuxième couche active secondaire 106, d'un troisième empilement 107 et d'une troisième couche active secondaire 108. Ensuite, comme illustré sur la figure 5, à l'aide d'une méthode de gravure sélective par exemple par masque dur, tout ou partie des couches prises parmi un deuxième empilement secondaire 105, une deuxième couche active secondaire 106, un troisième empilement secondaire 107 et une troisième couche active secondaire 108 sont gravées de façon à obtenir, soit l'empilement de couches composant un sous-pixel primaire 112, et/ou l'empilement de couches composant un sous-pixel tertiaire 113. Il n'est pas la peine de graver l'empilement pour obtenir un sous-pixel secondaire 111. La gravure est réalisée par zones correspondant à l'emplacement des sous-pixels primaires 112 et des sous-pixels tertiaires 113 à travers l'empilement constitué des couches ou empilements 102 à 108. Pour un sous-pixel primaire 112, les couches et empilements 108 et 107 sont gravés tandis que pour obtenir un sous-pixel tertiaire 113, les couches et empilements 108, 107, 106 et 105 sont gravés.

Une autre étape consiste à former, sur les couches devenues accessibles par l'étape de gravure sélective précédente, les couches de jonctions primaires 109d et/ou secondaires 109b et/ou tertiaires 109e. Préférentiellement, les couches de jonctions primaires 109d et/ou secondaires 109b et/ou tertiaires 109e sont réalisées en même temps et par la même technique. Des tranchées isolantes 14 sensiblement transversales à la surface 110 du substrat 101 sont ensuite réalisées par gravure. Les tranchées isolantes 14 permettent d'isoler électriquement et de définir physiquement les sous-pixels primaires 112 et/ou secondaires 112 et/ou tertiaires 113 entre eux. Ce procédé permet avantageusement de pouvoir obtenir, en même temps et par les mêmes techniques et sans étape de report et de collage, des sous-pixels primaires 112 et/ou des sous-pixels secondaires 111 et/ou des sous-pixels tertiaires 113. Dans une étape supplémentaire, des premiers contacts électriques primaires 131b, 131ii et/ou secondaires 131i, et/ou tertiaires 131iii sont formés sélectivement sur les couches de jonctions primaires 109d et/ou secondaires 109b et/ou tertiaires 109e. Dans une autre étape supplémentaire, un matériau isolant électriquement 15, comme du SiO₂, TiO₂, ZrOz ou Al₂O₃, mais préférentiellement du TiO₂, est déposé sélectivement dans tout ou partie des tranchées d'isolation 14. Ce dépôt peut être obtenu par exemple par un dépôt conforme d'oxyde. Puis, une étape ultérieure de gravure directive permet d'obtenir un dégagement à travers le matériau isolant électriquement 15. Ce dégagement peut déboucher avantageusement sur au moins une électrode (non représentée) contenue dans le substrat 101. Le dégagement peut ensuite être rempli par un matériau conducteur pour constituer au moins un deuxième contact électrique primaire et/ou secondaire et/ou tertiaire 132i, 132. Cette architecture permet avantageusement d'obtenir une électrode ou des électrodes communes à plusieurs sous-pixels primaires 112 et/ou secondaires 111 et/ou tertiaires 113.

Dans un autre mode de réalisation, dont les étapes sont illustrées sur les figures 4, 6, 7 et 9, une étape illustrée sur la figure 4 consiste à obtenir un empilement, sur un substrat 101, d'une couche tampon 102 semiconductrice, d'un premier empilement secondaire 103, d'une première couche active secondaire 104, d'une deuxième couche de jonction secondaire 109, d'une première jonction tunnel secondaire 121, d'un deuxième empilement secondaire 105, d'une deuxième couche active secondaire 106, d'une troisième couche de jonction 109a, d'une seconde jonction tunnel secondaire 122, d'un troisième empilement secondaire 107, d'une troisième couche active secondaire 108 et d'une première couche de jonction 109b. Une autre étape illustrée sur la figure 6 consiste à obtenir, par exemple par gravure sélective utilisant un masque dur d'épaisseur variable tridimensionnel, qui permet des épaisseurs de gravure différenciées dans une même étape, les emplacements préalables à la formation des premiers et seconds contacts électriques primaires, secondaires et tertiaires 131, 131a, 131b, 131c, 131d et 131e. Ainsi, les emplacements préalables aux premiers contacts primaires 131b et aux seconds contacts secondaires 131a, sont obtenus respectivement par arrêt de la gravure sur tout ou partie des couches de troisième empilement primaire 107a et secondaire 107. Egalement, les emplacements préalables aux seconds contacts primaires 131c et aux premiers contacts tertiaires 131d sont obtenus respectivement par arrêt de la gravure sur tout ou partie des couches de deuxième empilement primaire 105a et tertiaire 105b. Les emplacements préalables aux seconds contacts tertiaires sont obtenus par arrêt de la gravure sur tout ou partie des couches de premier empilement tertiaire 103b.

Une autre étape consiste à réaliser des tranchées d'isolation 14 traversant toutes les couches obtenues précédemment jusqu'au substrat 101. Les tranchées isolantes 14 permettent d'isoler électriquement et de définir physiquement les sous-pixels primaires 112 et/ou secondaires 111 et/ou tertiaires 113 entre eux. Ce procédé permet avantageusement de pouvoir obtenir, en même temps et par les mêmes techniques et sans étape de report et de collage, des sous-pixels primaires 112 et/ou des sous-pixels secondaires 111 et/ou des sous-pixels tertiaires 113. Dans une étape suivante illustrée sur la figure 9, une couche de matériau isolant électriquement 15 est formée de façon sélective sur les faces latérales des différents sous-pixels. Dans une étape suivante, les premiers et seconds contacts électriques primaires, secondaires et tertiaires 131, 131a, 131b, 131c, 131d et 131e sont formés sélectivement sur les faces libres et sensiblement parallèles à la surface support 110 du substrat 101 des différents sous-pixels définis précédemment par les étapes de gravure.

Dans ce qui précède, le pourcentage d'indium augmente au fur et à mesure de l'empilement consistant en le premier empilement 103a, la première couche active 104a, le deuxième empilement 105a et la deuxième couche active 106a. La première couche active 104a permet, grâce à son recouvrement avec le deuxième empilement 105a, d'augmenter le pourcentage d'indium dans le deuxième empilement 105a et donc au final d'obtenir un pourcentage d'indium dans la deuxième couche active 106a supérieur à 25%, de sorte à pouvoir émettre un rayonnement vert, que l'on ne peut pas obtenir avec de l'InGaAIP.

La première couche active primaire 104a a comme effet technique avantageux de permettre d'incorporer des quantités élevées d'indium, notamment dans une proportion supérieure à 20%, dans des puits quantiques d'InGaN sans dégrader l'efficacité des puits quantiques, notamment pour s'affranchir du recours à de l'InGaAIP.

Une seule architecture apte à générer plusieurs couleurs implique une fabrication simple et économique, notamment au niveau des masques de lithographie et gravure qui sont les mêmes quelle que soit la couleur d'émission envisagée, contrairement aux solutions connues qui envisagent de l'InGaAIP.

## Revendications

1. Dispositif optoélectronique (10) comprenant au moins un pixel (11), ledit au moins un pixel (11) comportant au moins deux sous-pixels (111, 112, 113) formés sur une surface support (110) d'un substrat (101) et décalés les uns des autres dans un plan général orienté parallèlement au plan de la surface support du substrat, chaque sous-pixel comprenant une diode électroluminescente apte à émettre un rayonnement lumineux, chaque pixel comprenant plusieurs ensembles de couches, chaque ensemble de couches comprenant :
- un empilement (103, 103a, 103b, 105, 105a, 107, 107a) comportant au moins deux couches principales (100b) de nitrure d'indium et de gallium, séparées deux à deux au moins par une couche intermédiaire (100a) de nitrure de gallium, au moins l'une des couches principales (100b) étant dopée selon un premier type de dopage choisi parmi un dopage de type N et un dopage de type P ; et
- au moins une couche active (104, 104a, 104b, 106, 106a, 108) formée en tout ou partie sur tout ou partie de l'empilement, la couche active comportant au moins un puits quantique ;
dans lequel chaque sous-pixel comprend au moins un premier des ensembles de couches, le premier ensemble de couches étant formé sur tout ou partie de la surface support (110), les deux couches principales (100b) de l'empilement du premier ensemble de couches répondant à la formule InzGa1-zN où 0≤z<0,1 ;
et dans lequel :
un premier sous-pixel (113) des sous-pixels du pixel comprend une première couche de jonction (109e) dopée selon un deuxième type de dopage, formée sur et en contact de la couche active (104b) du premier ensemble de couches du premier sous-pixel, de telle sorte que la couche active (104b) du premier ensemble de couches du premier sous-pixel est apte à émettre un rayonnement lumineux présentant sensiblement une première longueur d'onde, le deuxième type de dopage étant choisi parmi un dopage de type N et un dopage de type P, où le deuxième type de dopage est différent du premier type de dopage ;
un second sous-pixel (112) des sous-pixels du pixel comprend un deuxième ensemble de couches parmi les ensembles de couches, formé sur le premier ensemble de couches du second sous-pixel, les deux couches principales (100b) de l'empilement (105a) du deuxième ensemble de couches répondant à la formule InxGa1-xN où 0,1≤x<0,2 ; et
le second sous-pixel (112) comprend une deuxième couche de jonction (109d) formée sur et en contact de la couche active (106a) du second ensemble de couches, la deuxième couche de jonction (109d) étant dopée selon le deuxième type de dopage de telle sorte que la couche active (106a) du second ensemble de couches est apte à émettre un rayonnement lumineux présentant sensiblement une seconde longueur d'onde distincte de la première longueur d'onde.

2. Dispositif optoélectronique (10) selon la revendication 1, **caractérisé en ce que** le second sous-pixel (112) comprend :
une troisième couche de jonction (109c) formée en tout ou partie sur tout ou partie de la couche active (104a) du premier ensemble de couches du second sous-pixel et dopée selon ledit deuxième type de dopage, et
une première jonction tunnel (121a) formée entre tout ou partie de l'empilement (105a) du second ensemble de couches et tout ou partie de la troisième couche de jonction (109c).

3. Dispositif optoélectronique (10) selon la revendication 1 ou 2, **caractérisé en ce que** chaque sous-pixel (111, 112, 113) comprend au moins une couche tampon (102, 102a, 102b) semiconductrice formée sur la surface support (110) du substrat (101) et sur laquelle tout ou partie du premier ensemble de couches est formé.

4. Dispositif optoélectronique (10) selon l'une des revendications 1 à 3, **caractérisé en ce que** la seconde longueur d'onde du rayonnement lumineux apte à être émis par la couche active (106a) du deuxième ensemble de couches du second sous-pixel (112) est comprise entre 500 et 580 nm de sorte que le rayonnement lumineux apte à être émis par le second sous-pixel est sensiblement de couleur verte.

5. Dispositif optoélectronique (10) selon l'une des revendications 1 à 4, **caractérisé en ce que** le deuxième ensemble de couches du second sous-pixel (112) comprend :
des premiers contacts électriques (131b, 131ii) connectés électriquement avec la deuxième couche de jonction (109d) du second sous-pixel, et
des seconds contacts électriques (131c, 132i) connectés électriquement avec l'empilement (105a) du deuxième ensemble de couches du second sous-pixel.

6. Dispositif optoélectronique (10) selon l'une des revendications 1 à 5, **caractérisé en ce que** :
la couche active (104) de chaque premier ensemble de couches comprend une proportion d'indium supérieure à la proportion d'indium dans l'empilement (103) du premier ensemble de couches, et/ou
la couche active (106) de chaque second ensemble de couches comprend une proportion d'indium supérieure à la proportion d'indium dans l'empilement (105) du second ensemble de couches.

7. Dispositif optoélectronique (10) selon l'une des revendications 1 à 6, **caractérisé en ce que** le pixel comprend un troisième sous-pixel (111) comprenant une diode électroluminescente apte à émettre un troisième rayonnement lumineux, et le troisième sous-pixel comprenant :
un deuxième des ensembles de couches, formé sur le premier ensemble de couches du troisième sous-pixel, les couches principales (100b) de l'empilement (105) du deuxième ensemble de couches répondant à la formule InxGa1-xN où 0,1≤x<0,2 ; et
un troisième des ensembles de couches, formé en tout ou partie sur tout ou partie de la couche active (106) du deuxième ensemble de couches du troisième sous-pixel, les couches principales (100b) de l'empilement (107) du troisième ensemble de couches répondant à la formule InyGa1-yN où 0,2≤y≤0,35, le troisième sous-pixel comprenant une quatrième couche de jonction (109b) formée sur et en contact de la couche active (108) du troisième ensemble de couches, la quatrième couche de jonction (109b) du troisième sous-pixel étant dopée selon le deuxième type de dopage, de telle sorte que la couche active (108) du troisième ensemble de couches est apte à émettre un rayonnement lumineux présentant sensiblement une troisième longueur d'onde.

8. Dispositif optoélectronique (10) selon la revendication 7, **caractérisé en ce que** le troisième sous-pixel (111) comprend :
- une cinquième couche de jonction (109a) formée en tout ou partie sur tout ou partie de la couche active (106) du deuxième ensemble de couches du troisième sous-pixel et dopée selon ledit deuxième type de dopage, et
- une jonction tunnel (122) formée entre tout ou partie de l'empilement (107) du troisième ensemble de couches du troisième sous-pixel et tout ou partie de la cinquième couche de jonction (109a) du troisième sous-pixel.

9. Dispositif optoélectronique (10) selon l'une des revendications 7 ou 8, **caractérisé en ce que** la couche active (108) du troisième ensemble de couches comprend une proportion d'indium supérieure à la proportion d'indium dans l'empilement (107) du troisième ensemble de couches.

10. Dispositif optoélectronique (10) selon l'une des revendications 7 à 9, **caractérisé en ce que** la troisième longueur d'onde est comprise entre 590 et 680 nm de sorte que le rayonnement lumineux apte à être émis par le troisième sous-pixel (111) est sensiblement de couleur rouge.

11. Dispositif optoélectronique (10) selon l'une des revendications 7 à 10, **caractérisé en ce que** le troisième sous-pixel (111) comprend des premiers contacts électriques (131, 131i) connectés électriquement avec la quatrième couche de jonction (109b) du troisième ensemble de couches et des seconds contacts électriques (131a, 132) connectés électriquement avec l'empilement (107) du troisième ensemble de couches.

12. Dispositif optoélectronique (10) selon l'une des revendications 1 à 11, **caractérisé en ce que** le premier sous-pixel (113) comprend :
- au moins un empilement (105b) formé en tout ou partie sur tout ou partie de la première couche de jonction (109e) du premier sous-pixel et comportant au moins deux couches principales (100b) de nitrure d'indium et de gallium répondant à la formule InxGa1-xN où 0,1≤x<0,2 séparées deux à deux au moins par une couche intermédiaire (100a) de nitrure de gallium, au moins l'une des couches principales (100b) du premier sous-pixel étant dopée selon ledit premier type de dopage ; et
- une jonction tunnel (121b) formée entre tout ou partie de l'empilement (105b) et tout ou partie de la première couche de jonction (109e) du premier sous-pixel.

13. Dispositif optoélectronique (10) selon l'une des revendications 1 à 12, **caractérisé en ce que** la première longueur d'onde est comprise entre 400 et 490 nm de sorte que le rayonnement lumineux apte à être émis par le premier sous-pixel est sensiblement de couleur bleue.

14. Dispositif optoélectronique (10) selon l'une des revendications 12 à 13, **caractérisé en ce que** le premier sous-pixel (113) comprend des premiers contacts électriques (131d, 131iii) connectés électriquement avec la première couche de jonction (109e) du premier sous-pixel et des seconds contacts électriques (131e, 132i) connectés électriquement avec l'empilement (103b) du premier ensemble de couches du premier sous-pixel.

15. Dispositif optoélectronique (10) selon l'une des revendications 1 à 14, **caractérisé en ce que** les sous-pixels (111, 112, 113) sont isolés électriquement les uns des autres par l'intermédiaire d'une tranchée isolante (14) orientée transversalement par rapport au plan général orienté parallèlement au plan de la face support (110) du substrat (101).

16. Procédé de fabrication d'un dispositif optoélectronique (10), comportant une phase de formation d'au moins deux sous-pixels (111, 112, 113) d'un pixel, le procédé incluant les étapes suivantes :
a) formation d'un substrat (101) ayant une surface support (110) ;
b) formation de plusieurs ensembles de couches incluant un premier ensemble de couches pour chaque sous-pixel, le premier ensemble de couches étant formé sur tout ou partie de la face support (110), chaque ensemble de couches comprenant :
un empilement (103, 103a, 103b, 105, 105a, 107, 107a) comportant au moins deux premières couches principales (100b) de nitrure d'indium et de gallium, séparées deux à deux au moins par une première couche intermédiaire (100a) de nitrure de gallium, au moins l'une des premières couches principales (100b) étant dopée selon un premier type de dopage choisi parmi un dopage de type N et un dopage de type P, les premières couches principales (100b) du premier ensemble de couches de chaque sous-pixel répondant à la formule InzGa1-zN où 0≤z<0,1 ; et
au moins une couche active (104, 104a, 104b, 106, 106a, 108) formée en tout ou partie surtout ou partie de l'empilement, la couche active comportant au moins un puits quantique ;
c) formation, sur tout ou partie de la couche active (104b) du premier ensemble de couches d'au moins un premier sous-pixel (113) des sous-pixels, d'une première couche de jonction (109e) dopée selon un deuxième type de dopage, formée sur et en contact de la couche active (104b) du premier ensemble de couches du premier sous-pixel, de telle sorte que la couche active (104b) du premier ensemble de couches du premier sous-pixel est apte à émettre un rayonnement lumineux présentant sensiblement une première longueur d'onde, le deuxième type de dopage étant choisi parmi un dopage de type N et un dopage de type P, où le deuxième type de dopage est différent du premier type de dopage ;
d) formation, sur tout ou partie de la couche active (104a) du premier ensemble de couches d'au moins un second sous-pixel (112) des sous-pixels, d'un deuxième des ensembles de couches, les couches principales (100b) de l'empilement (105a) du deuxième ensemble de couches répondant à la formule InxGa1-xN où 0,1≤x<0,2 ; et
e) formation de tout ou partie d'une deuxième couche de jonction (109d) sur et en contact de la couche active (106a) du deuxième ensemble de couches du second sous-pixel et dopée selon le deuxième type de dopage, de telle sorte que la couche active (106a) du deuxième ensemble de couches est apte à émettre un rayonnement lumineux présentant sensiblement une seconde longueur d'onde distincte de la première longueur d'onde.

17. Procédé de fabrication selon la revendication 16, comprenant une étape de formation d'une couche tampon (102, 102a, 102b) semiconductrice sur la face support (110) du substrat (101), tout ou partie du premier ensemble de couches étant formé sur tout ou partie de la couche tampon.

18. Procédé de fabrication selon l'une des revendications 16 ou 17, comprenant une étape de formation de tout ou partie d'une troisième couche de jonction (109c) dopée selon ledit deuxième type de dopage sur tout ou partie de la couche active (104a) du premier ensemble de couches du second sous-pixel (112), et d'une première jonction tunnel (121a) entre tout ou partie de l'empilement (105a) du deuxième ensemble de couches et tout ou partie de la troisième couche de jonction (109c), du second sous-pixel.

19. Procédé de fabrication selon l'une des revendications 16 à 18, comprenant une étape de formation de premiers contacts électriques (131b, 131ii) connectés électriquement avec la deuxième couche de jonction (109d) et de seconds contacts électriques (131c, 132i) connectés électriquement avec l'empilement (105a) du deuxième ensemble de couches du second sous-pixel (112).

20. Procédé de fabrication d'un dispositif optoélectronique (10) selon l'une des revendications 16 à 19, comprenant la formation d'au moins un troisième des sous-pixels (111) du pixel comprenant des étapes de :
formation d'un deuxième des ensemble de couches sur tout ou partie de la couche active (104) du premier ensemble de couches du troisième sous-pixel, les couches principales (100b) du second ensemble de couches répondant à la formule InxGa1-xN où 0,1≤x<0,2 ;
formation d'un troisième des ensembles de couches sur tout ou partie de la couche active (106) du second ensemble de couches du troisième sous-pixel, les couches principales (100b) du troisième ensemble de couches répondant à la formule InyGa1-yN où 0,2≤y≤0,35 ; et
formation de tout ou partie d'au moins une troisième couche de jonction (109b) sur et en contact de la couche active (108) du troisième ensemble de couches, la troisième couche de jonction (109b) étant dopée selon le deuxième type de dopage, de telle sorte que la couche active (108) du troisième ensemble de couches est apte à émettre un rayonnement lumineux présentant sensiblement une troisième longueur d'onde.

21. Procédé de fabrication selon la revendication 20, **caractérisé en ce que** la formation du troisième sous-pixel (111) du pixel comprend des étapes :
de formation de tout ou partie d'au moins une quatrième couche de jonction (109) sur tout ou partie de la couche active (104) du premier ensemble de couches du troisième sous-pixel, la quatrième couche de jonction (109) étant dopée selon ledit deuxième type de dopage ;
formation de tout ou partie d'une première jonction tunnel (121) entre tout ou partie de l'empilement (105) du deuxième ensemble de couches du troisième sous-pixel et tout ou partie de la quatrième couche de jonction (109) ; et
formation de tout ou partie d'au moins une cinquième couche de jonction (109a) dopée selon ledit deuxième type de dopage sur tout ou partie de la couche active (106) du deuxième ensemble de couches du troisième sous-pixel et d'une deuxième jonction tunnel (122) entre tout ou partie de l'empilement (107) du troisième ensemble de couches et tout ou partie de la cinquième couche de jonction (109a).

22. Procédé de fabrication selon l'une des revendications 20 et 21, **caractérisé en ce que** la formation du troisième sous-pixel (111) du pixel comprend une étape de formation de premiers contacts électriques (131, 131i) connectés électriquement avec la troisième couche de jonction (109b) et de seconds contacts électriques (131a, 132) connectés électriquement avec l'empilement (107) du troisième ensemble de couches du troisième sous-pixel.

23. Procédé de fabrication selon l'une des revendications 16 à 22, dans lequel la formation du premier sous-pixel (113) comprend les étapes de formation d'au moins une première couche de jonction (109e) dopée selon le deuxième type de dopage, sur et en contact de la couche active (104b) du premier ensemble de couches du premier sous-pixel.

24. Procédé de fabrication selon la revendication 23, **caractérisé en ce que** la formation du premier sous-pixel (113) comprend les étapes suivantes :
formation d'au moins un deuxième empilement (105b) en tout ou partie surtout ou partie de la sixième couche de jonction (109e) du premier sous-pixel et comportant au moins deux deuxièmes couches principales de nitrure d'indium et de gallium répondant à la formule InxGa1-xN où 0,1≤x<0,2 séparées deux à deux au moins par une deuxième couche intermédiaire de nitrure de gallium, au moins l'une des deuxièmes couches principales étant dopée selon ledit premier type de dopage ; et
formation d'une jonction tunnel (121b) entre tout ou partie du deuxième empilement (105b) et tout ou partie de la sixième couche de jonction (109e) du premier sous-pixel.

25. Procédé de fabrication selon l'une des revendications 23 et 24, **caractérisé en ce que** la phase de formation du premier sous-pixel (113) comprend une étape de formation de contacts électriques (131d, 131iii) connectés électriquement avec la sixième couche de jonction (109e) du premier sous-pixel, et de seconds contacts électriques (131e, 132i) connectés électriquement avec l'empilement (103b) du premier ensemble de couches du premier sous-pixel.

26. Procédé de fabrication selon l'une des revendications 22 à 25, **caractérisé en ce que** les premiers ensembles de couches des premier, second et troisième sous-pixels (111, 112, 113) sont formés en même temps et avec la même technique, et **en ce que** les deuxièmes ensembles de couches des second et troisième sous-pixels (111, 112) sont formés en même temps et avec la même technique.

27. Procédé de fabrication selon l'une des revendications 21 à 26, dans lequel au moins l'une des conditions suivantes est vérifiée :
- les empilements (103, 103a, 103b) du premier ensemble de couches de deux sous-pixels distincts sont formés en même temps et avec une même technique,
- les empilements (105, 105a, 105b) du deuxième ensemble de couches de deux sous-pixels distincts sont formés en même temps et avec une même technique,
- les couches actives (104, 104a, 104b) du premier ensemble de couches de deux sous-pixels distincts sont formées en même temps et avec une même technique,
- les couches actives (106, 106a) du deuxième ensemble de couches de deux sous-pixels distincts sont formées en même temps et avec une même technique,
- les empilements (107a, 107) du troisième ensemble de couches de deux sous-pixels distincts sont formés en même temps et avec une même technique,
- les jonctions tunnels (121, 121a, 121b) de deux sous-pixels distincts sont formées en partie en même temps et avec une même technique.

## Patentansprüche

1. Optoelektronische Vorrichtung (10), die mindestens ein Pixel (11) umfasst, wobei das mindestens eine Pixel (11) mindestens zwei Subpixel (111, 112, 113) beinhaltet, die auf einer Trägeroberfläche (110) eines Substrats (101) gebildet und in einer allgemeinen Ebene, die parallel zur Ebene der Trägeroberfläche des Substrats ausgerichtet ist, voneinander versetzt sind, wobei jedes Subpixel eine Leuchtdiode umfasst, die geeignet ist, Lichtstrahlung zu emittieren, wobei jedes Pixel mehrere Schichtanordnungen umfasst, wobei jede Schichtanordnung umfasst:
- Einen Stapel (103, 103a, 103b, 105, 105a, 107, 107a), der mindestens zwei Hauptschichten (100b) aus Indiumnitrid und Gallium beinhaltet, die mindestens zu zwei und zwei durch eine Zwischenschicht (100a) aus Galliumnitrid getrennt sind, wobei mindestens eine der Hauptschichten (100b) gemäß einem ersten Dotierungstyp dotiert ist, der aus einer Dotierung des n-Typs und des p-Typs ausgewählt ist; und
- mindestens eine aktive Schicht (104, 104a, 104b, 106, 106a, 108), die ganz oder zum Teil auf dem ganzen oder einem Teil des Stapels gebildet ist, wobei die aktive Schicht mindestens einen Quantentopf beinhaltet;
wobei jedes Subpixel mindestens eine erste der Schichtanordnungen umfasst, wobei die erste Schichtanordnung auf der ganzen oder einem Teil der Trägeroberfläche (110) gebildet ist, wobei die zwei Hauptschichten (100b) des Stapels der ersten Schichtanordnung der Formel InzGa1-zN entsprechen, wobei 0≤z<0,1;
und wobei:
Ein erstes Subpixel (113) der Subpixel des Pixels eine erste Verbindungsschicht (109e) umfasst, die gemäß einem zweiten Dotierungstyp dotiert ist, und derart auf und in Kontakt mit der aktiven Schicht (104b) der ersten Schichtanordnung des ersten Subpixels gebildet ist, dass die aktive Schicht (104b) der ersten Schichtanordnung des ersten Subpixels geeignet ist, Lichtstrahlung zu emittieren, die im Wesentlichen eine erste Wellenlänge aufweist, wobei der zweite Dotierungstyp aus einer Dotierung des n-Typs und des p-Typs ausgewählt ist, wobei der zweite Dotierungstyp vom ersten Dotierungstyp verschieden ist;
ein zweites Subpixel (112) der Subpixel des Pixels eine zweite Schichtanordnung unter den Schichtanordnungen umfasst, die auf der ersten Schichtanordnung des zweiten Subpixels gebildet ist, wobei die zwei Hauptschichten (100b) des Stapels (105a) der zweiten Schichtanordnung der Formel InxGa1-xN entsprechen, wobei 0,1≤x<0,2; und
das zweite Subpixel (112) eine zweite Verbindungsschicht (109d) umfasst, die auf und in Kontakt mit der aktiven Schicht (106a) der zweiten Schichtanordnung gebildet ist, wobei die zweite Verbindungsschicht (109d) gemäß dem zweiten Dotierungstyp derart dotiert ist, dass die aktive Schicht (106a) der zweiten Schichtanordnung geeignet ist, Lichtstrahlung zu emittieren, die im Wesentlichen eine zweite Wellenlänge aufweist, die sich von der ersten Wellenlänge unterscheidet.

2. Optoelektronische Vorrichtung (10) nach Anspruch 1, **dadurch gekennzeichnet, dass** das zweite Subpixel (112) umfasst:
Eine dritte Verbindungsschicht (109c), die ganz oder zum Teil auf der ganzen oder einem Teil der aktiven Schicht (104a) der ersten Schichtanordnung des zweiten Subpixels gebildet und gemäß dem zweiten Dotierungstyp dotiert ist, und
eine erste Tunnelverbindung (121a), die zwischen dem ganzen oder einem Teil des Stapels (105a) der zweiten Schichtanordnung und der ganzen oder einem Teil der dritten Verbindungsschicht (109c) gebildet wird.

3. Optoelektronische Vorrichtung (10) nach Anspruch 1 oder 2, **dadurch gekennzeichnet, dass** jedes Subpixel (111, 112, 113) mindestens eine halbleitende Pufferschicht (102, 102a, 102b) umfasst, die auf der Trägeroberfläche (110) des Substrats (101) gebildet ist, und auf der die ganze oder ein Teil der ersten Schichtanordnung gebildet ist.

4. Optoelektronische Vorrichtung (10) nach einem der Ansprüche 1 bis 3, **dadurch gekennzeichnet, dass** die zweite Wellenlänge der Lichtstrahlung, die geeignet ist, von der aktiven Schicht (106a) der zweiten Schichtanordnung des zweiten Subpixels (112) emittiert zu werden, zwischen 500 und 580 nm liegt, so dass die Lichtstrahlung, die geeignet ist, vom zweiten Subpixel emittiert zu werden, im Wesentlichen von grüner Farbe ist.

5. Optoelektronische Vorrichtung (10) nach einem der Ansprüche 1 bis 4, **dadurch gekennzeichnet, dass** die zweite Schichtanordnung des zweiten Subpixels (112) umfasst:
Erste elektrische Kontakte (131b, 131ii), die elektrisch mit der zweiten Verbindungsschicht (109d) des zweiten Subpixels verbunden sind, und
zweite elektrische Kontakte (131c, 132i), die elektrisch mit dem Stapel (105a) der zweiten Schichtanordnung des zweiten Subpixels verbunden sind.

6. Optoelektronische Vorrichtung (10) nach einem der Ansprüche 1 bis 5, **dadurch gekennzeichnet, dass**:
Die aktive Schicht (104) jeder ersten Schichtanordnung einen Indiumanteil umfasst, der größer ist als der Indiumanteil im Stapel (103) der ersten Schichtanordnung, und/oder
die aktive Schicht (106) jeder zweiten Schichtanordnung einen Indiumanteil umfasst, der größer ist als der Indiumanteil im Stapel (105) der zweiten Schichtanordnung.

7. Optoelektronische Vorrichtung (10) nach einem der Ansprüche 1 bis 6, **dadurch gekennzeichnet, dass** das Pixel ein drittes Subpixel (111) umfasst, das eine Leuchtdiode umfasst, die geeignet ist, eine dritte Lichtstrahlung zu emittieren, und das dritte Subpixel umfasst:
Eine zweite der Schichtanordnungen, die auf der ersten Schichtanordnung des dritten Subpixels gebildet ist, wobei die Hauptschichten (100b) des Stapels (105) der zweiten Schichtanordnung der Formel InxGa1-xN entsprechen, wobei 0,1≤x<0,2; und
eine dritte der Schichtanordnungen, die ganz oder zum Teil auf der ganzen oder auf einem Teil der aktiven Schicht (106) der zweiten Schichtanordnung des dritten Subpixels gebildet ist, wobei die Hauptschichten (100b) des Stapels (107) der dritten Schichtanordnung der Formel InyGa1-yN entsprechen, wobei 0,2 ≤ y ≤ 0,35, wobei das dritte Subpixel eine vierte Verbindungsschicht (109b) umfasst, die auf und in Kontakt mit der aktiven Schicht (108) der dritten Schichtanordnung gebildet ist, wobei die vierte Verbindungsschicht (109b) des dritten Subpixels gemäß dem zweiten Dotierungstyp derart dotiert ist, dass die aktive Schicht (108) der dritten Schichtanordnung geeignet ist, Lichtstrahlung zu emittieren, die im Wesentlichen eine dritte Wellenlänge aufweist.

8. Optoelektronische Vorrichtung (10) nach Anspruch 7, **dadurch gekennzeichnet, dass** das dritte Subpixel (111) umfasst:
- Eine fünfte Verbindungsschicht (109a), die ganz oder zum Teil auf der ganzen oder einem Teil der aktiven Schicht (106) der zweiten Schichtanordnung des dritten Subpixels gebildet und gemäß dem zweiten Dotierungstyp dotiert ist, und
- eine Tunnelverbindung (122), die zwischen dem ganzen oder einem Teil des Stapels (107) der dritten Schichtanordnung des dritten Subpixels und der ganzen oder einem Teil der fünften Verbindungsschicht (109a) des dritten Subpixels gebildet ist.

9. Optoelektronische Vorrichtung (10) nach einem der Ansprüche 7 oder 8, **dadurch gekennzeichnet, dass** die aktive Schicht (108) der dritten Schichtanordnung einen Indiumanteil umfasst, der größer ist als der Indiumanteil im Stapel (107) der dritten Schichtanordnung.

10. Optoelektronische Vorrichtung (10) nach einem der Ansprüche 7 bis 9, **dadurch gekennzeichnet, dass** die dritte Wellenlänge zwischen 590 und 680 nm liegt, so dass die Lichtstrahlung, die geeignet ist, vom dritten Subpixel (111) emittiert zu werden, im Wesentlichen von roter Farbe ist.

11. Optoelektronische Vorrichtung (10) nach einem der Ansprüche 7 bis 10, **dadurch gekennzeichnet, dass** das dritte Subpixel (111) erste elektrische Kontakte (131, 131i) umfasst, die elektrisch mit der vierten Verbindungsschicht (109b) der dritten Schichtanordnung verbunden sind, und zweite elektrische Kontakte (131a, 132), die elektrisch mit dem Stapel (107) der dritten Schichtanordnung verbunden sind.

12. Optoelektronische Vorrichtung (10) nach einem der Ansprüche 1 bis 11, **dadurch gekennzeichnet, dass** das erste Subpixel (113) umfasst:
- Mindestens einen Stapel (105b), der ganz oder zum Teil auf der ganzen oder einem Teil der ersten Verbindungsschicht (109e) des ersten Subpixels gebildet ist und mindestens zwei Hauptschichten (100b) aus Indiumnitrid und Gallium beinhaltet, die der Formel InxGa1-xN entsprechen, wobei 0,1≤x<0,2, und mindestens zu zwei und zwei durch eine Zwischenschicht (100a) aus Galliumnitrid getrennt sind, wobei mindestens die eine der Hauptschichten (100b) des ersten Subpixels gemäß dem ersten Dotierungstyp dotiert ist; und
- eine Tunnelverbindung (121b), die zwischen dem ganzen oder einem Teil des Stapels (105b) und dem ganzen oder einem Teil der ersten Verbindungsschicht (109e) des ersten Subpixels gebildet ist.

13. Optoelektronische Vorrichtung (10) nach einem der Ansprüche 1 bis 12, **dadurch gekennzeichnet, dass** die erste Wellenlänge zwischen 400 und 490 nm liegt, so dass die Lichtstrahlung, die geeignet ist, vom ersten Subpixel emittiert zu werden, im Wesentlichen von blauer Farbe ist.

14. Optoelektronische Vorrichtung (10) nach einem der Ansprüche 12 bis 13, **dadurch gekennzeichnet, dass** das erste Subpixel (113) erste elektrische Kontakte (131d, 131iii) umfasst, die elektrisch mit der ersten Verbindungsschicht (109e) des ersten Subpixels verbunden sind, und zweite elektrische Kontakte (131e, 132i), die elektrisch mit dem Stapel (103b) der ersten Schichtanordnung des ersten Subpixels verbunden sind.

15. Optoelektronische Vorrichtung (10) nach einem der Ansprüche 1 bis 14, **dadurch gekennzeichnet, dass** die Subpixel (111, 112, 113) elektrisch voneinander mittels einer isolierenden Schneise (14) isoliert sind, die quer zur allgemeinen Ebene ausgerichtet ist, die parallel zur Ebene der Trägerfläche (110) des Substrats (101) ausgerichtet ist.

16. Verfahren zur Herstellung einer optoelektronischen Vorrichtung (10), das eine Phase der Bildung von mindestens zwei Subpixeln (111, 112, 113) eines Pixels beinhaltet, wobei das Verfahren die folgenden Schritte einschließt:
a) Bildung eines Substrats (101), das eine Trägeroberfläche (110) hat;
b) Bildung mehrerer Schichtanordnungen, die eine erste Schichtanordnung für jedes Subpixel einschließen, wobei die erste Schichtanordnung auf der ganzen oder einem Teil der Trägerfläche (110) gebildet wird, wobei jede Schichtanordnung umfasst:
Einen Stapel (103, 103a, 103b, 105, 105a, 107, 107a), der mindestens zwei erste Hauptschichten (100b) aus Indiumnitrid und Gallium beinhaltet, die mindestens zu zwei und zwei durch eine erste Zwischenschicht (100a) aus Galliumnitrid getrennt sind, wobei mindestens eine der ersten Hauptschichten (100b) gemäß einem ersten Dotierungstyp dotiert ist, der aus einer Dotierung des n-Typs und des p-Typs ausgewählt ist, wobei die ersten Hauptschichten (100b) der ersten Anordnung von Schichten jedes Subpixels der Formel InzGa1-zN entsprechen, wobei 0≤z<0,1; und
mindestens eine aktive Schicht (104, 104a, 104b, 106, 106a, 108), die ganz oder zum Teil, hauptsächlich zum Teil, aus dem Stapel gebildet ist, wobei die aktive Schicht mindestens einen Quantentopf beinhaltet;
c) Bildung, auf der ganzen oder einem Teil der aktiven Schicht (104b) der ersten Schichtanordnung mindestens eines ersten Subpixels (113) der Subpixel, einer ersten Verbindungsschicht (109e), die gemäß einem zweiten Dotierungstyp dotiert ist, und derart auf und in Kontakt mit der aktiven Schicht (104b) der ersten Schichtanordnung des ersten Subpixels gebildet ist, dass die aktive Schicht (104b) der ersten Schichtanordnung des ersten Subpixels geeignet ist, Lichtstrahlung zu emittieren, die im Wesentlichen eine erste Wellenlänge aufweist, wobei der zweite Dotierungstyp aus einer Dotierung des n-Typs und des p-Typs ausgewählt ist, wobei der zweite Dotierungstyp vom ersten Dotierungstyp verschieden ist;
d) Bildung, auf der ganzen oder einem Teil der aktiven Schicht (104a) der ersten Schichtanordnung von mindestens einem zweiten Subpixel (112) der Subpixel, einer zweiten der Schichtanordnungen, wobei die Hauptschichten (100b) des Stapels (105a) der zweiten Schichtanordnung der Formel InxGa1-xN entsprechen, wobei 0,1^x<0,2; und
e) Bildung einer ganzen oder eines Teils einer zweiten Verbindungsschicht (109d) auf und in Kontakt mit der aktiven Schicht (106a) der zweiten Schichtanordnung des zweiten Subpixels, und derart dotiert gemäß dem zweiten Dotierungstyp, dass die aktive Schicht (106a) der zweiten Schichtanordnung geeignet ist, Lichtstrahlung zu emittieren, die im Wesentlichen eine zweite Wellenlänge aufweist, die sich von der ersten Wellenlänge unterscheidet.

17. Herstellungsverfahren nach Anspruch 16, einen Schritt zur Bildung einer halbleitenden Pufferschicht (102, 102a, 102b) auf der Trägerfläche (110) des Substrats (101) umfassend, wobei die ganze oder ein Teil der ersten Schichtanordnung auf der ganzen oder einem Teil der Pufferschicht gebildet wird.

18. Herstellungsverfahren nach einem der Ansprüche 16 oder 17, einen Schritt der Bildung einer ganzen oder eines Teils einer dritten Verbindungsschicht (109c) umfassend, die gemäß dem zweiten Dotierungstyp auf der ganzen oder einem Teil der aktiven Schicht (104a) der ersten Schichtanordnung des zweiten Subpixels (112) dotiert ist, und einer ersten Tunnelverbindung (121a) zwischen dem ganzen oder einem Teil des Stapels (105a) der zweiten Schichtanordnung und der ganzen oder einem Teil der dritten Verbindungsschicht (109c) des zweiten Subpixels.

19. Herstellungsverfahren nach einem der Ansprüche 16 bis 18, einen Schritt der Bildung von ersten elektrischen Kontakten (131b, 131ii) umfassend, die elektrisch mit der zweiten Verbindungsschicht (109d) verbunden sind, und zweiten elektrischen Kontakten (131c, 132i), die elektrisch mit dem Stapel (105a) der zweiten Schichtanordnung des zweiten Subpixels (112) verbunden sind.

20. Verfahren zur Herstellung einer optoelektronischen Vorrichtung (10) nach einem der Ansprüche 16 bis 19, die Bildung von mindestens einem dritten der Subpixel (111) des Pixels umfassend, die Schritte umfassend:
Bildung einer zweiten Schichtanordnung auf der ganzen oder einem Teil der aktiven Schicht (104) der ersten Schichtanordnung des dritten Subpixels, wobei die Hauptschichten (100b) der zweiten Schichtanordnung der Formel InxGa1-xN entsprechen, wobei 0,1≤x<0,2;
Bildung einer dritten der Schichtanordnungen auf der ganzen oder einem Teil der aktiven Schicht (106) der zweiten Schichtanordnung des dritten Subpixels, wobei die Hauptschichten (100b) der dritten Schichtanordnung der Formel InyGa1-yN entsprechen, wobei 0,2^y^0,35; und
Bildung von mindestens einer ganzen oder eines Teils einer dritten Verbindungsschicht (109b) auf und in Kontakt mit der aktiven Schicht (108) der dritten Schichtanordnung, wobei die dritte Verbindungsschicht (109b) derart gemäß dem zweiten Dotierungstyp dotiert ist, dass die aktive Schicht (108) der dritten Schichtanordnung geeignet ist, Lichtstrahlung zu emittieren, die im Wesentlichen eine dritte Wellenlänge aufweist.

21. Herstellungsverfahren nach Anspruch 20, **dadurch gekennzeichnet, dass** die Bildung des dritten Subpixels (111) des Pixels die Schritte umfasst:
Der Bildung einer ganzen oder eines Teils mindestens einer vierten Verbindungsschicht (109) auf der ganzen oder einem Teil der aktiven Schicht (104) der ersten Schichtanordnung des dritten Subpixels, wobei die vierte Verbindungsschicht (109) gemäß dem zweiten Dotierungstyp dotiert ist;
Bildung einer ganzen oder eines Teils einer ersten Tunnelverbindung (121) zwischen dem ganzen oder einem Teil des Stapels (105) der zweiten Schichtanordnung des dritten Subpixels und der ganzen oder einem Teil der vierten Verbindungsschicht (109); und
Bildung einer ganzen oder eines Teils mindestens einer fünften Verbindungsschicht (109a), die gemäß dem zweiten Dotierungstyp auf der ganzen oder einem Teil der aktiven Schicht (106) der zweiten Schichtanordnung des dritten Subpixels und einer zweiten Tunnelverbindung (122) dotiert ist, zwischen dem ganzen oder einem Teil des Stapels (107) der dritten Schichtanordnung und der ganzen oder einem Teil der fünften Verbindungsschicht (109a).

22. Herstellungsverfahren nach einem der Ansprüche 20 und 21, **dadurch gekennzeichnet, dass** die Bildung des dritten Subpixels (111) des Pixels einen Schritt der Bildung von ersten elektrischen Kontakten (131, 131i) umfasst, die elektrisch mit der dritten Verbindungsschicht (109b) verbunden sind, und von zweiten elektrischen Kontakten (131a, 132), die elektrisch mit dem Stapel (107) der dritten Schichtanordnung des dritten Subpixels verbunden sind.

23. Herstellungsverfahren nach einem der Ansprüche 16 bis 22, wobei die Bildung des ersten Subpixels (113) die Schritte zur Bildung mindestens einer ersten Verbindungsschicht (109e) umfasst, die gemäß dem zweiten Dotierungstyp dotiert ist, auf und in Kontakt mit der aktiven Schicht (104b) der ersten Schichtanordnung des ersten Subpixels.

24. Herstellungsverfahren nach Anspruch 23, **dadurch gekennzeichnet, dass** die Bildung des ersten Subpixels (113) die folgenden Schritte umfasst:
Bildung von mindestens einem ganzen oder eines Teils eines zweiten Stapels (105b) auf der ganzen oder einem Teil der sechsten Verbindungsschicht (109e) des ersten Subpixels, und mindestens zwei zweite Hauptschichten aus Indiumnitrid und Gallium beinhaltend, die der Formel InxGa1-xN entsprechen, wobei 0,1 ≤ x<0,2, die zu zwei und zwei durch mindestens eine zweite Zwischenschicht aus Galliumnitrid getrennt sind, wobei mindestens eine der zweiten Hauptschichten gemäß dem ersten Dotierungstyp dotiert ist; und
Bildung einer Tunnelverbindung (121b) zwischen dem ganzen oder einem Teil des zweiten Stapels (105b) und der ganzen oder einem Teil der sechsten Verbindungsschicht (109e) des ersten Subpixels.

25. Herstellungsverfahren nach einem der Ansprüche 23 und 24, **dadurch gekennzeichnet, dass** die Phase der Bildung des ersten Subpixels (113) einen Schritt der Bildung von elektrischen Kontakten (131d, 131iii) umfasst, die elektrisch mit der sechsten Verbindungsschicht (109e) des ersten Subpixels verbunden sind, und von zweiten elektrischen Kontakten (131e, 132i), die elektrisch mit dem Stapel (103b) der ersten Schichtanordnung des ersten Subpixels verbunden sind.

26. Herstellungsverfahren nach den Ansprüchen 22 bis 25, **dadurch gekennzeichnet, dass** die ersten Schichtanordnungen der ersten, zweiten und dritten Subpixel (111, 112, 113) gleichzeitig und mit derselben Technik gebildet werden, und dass die zweiten Schichtanordnungen der zweiten und dritten Subpixel (111, 112) gleichzeitig und mit derselben Technik gebildet werden.

27. Herstellungsverfahren nach einem der Ansprüche 21 bis 26, wobei mindestens eine der folgenden Bedingungen verifiziert ist:
- Die Stapel (103, 103a, 103b) der ersten Schichtanordnung aus zwei unterschiedlichen Subpixeln werden gleichzeitig und mit derselben Technik gebildet,
- die Stapel (105, 105a, 105b) der zweiten Schichtanordnung aus zwei unterschiedlichen Subpixeln werden gleichzeitig und mit derselben Technik gebildet,
- die aktiven Schichten (104, 104a, 104b) der ersten Schichtanordnung aus zwei unterschiedlichen Subpixeln werden gleichzeitig und mit derselben Technik gebildet,
- die aktiven Schichten (106, 106a) der zweiten Schichtanordnung aus zwei unterschiedlichen Subpixeln werden gleichzeitig und mit derselben Technik gebildet,
- die Stapel (107a, 107) der dritten Schichtanordnung aus zwei unterschiedlichen Subpixeln werden gleichzeitig und mit derselben Technik gebildet,
- die Tunnelverbindungen (121, 121a, 121b) der zwei unterschiedlichen Subpixel werden zum Teil gleichzeitig und mit derselben Technik gebildet.

## Claims

1. An optoelectronic device (10) comprising at least one pixel (11), said at least one pixel (11) including at least two sub-pixels (111, 112, 113) formed over a support surface (110) of a substrate (101) and offset from each other in a general plane directed parallel to the plane of the support surface of the substrate, each sub-pixel comprising a light-emitting diode adapted to emit a light radiation, each pixel comprising several layer sets, each layer set comprising :
- a stack (103, 103a, 103b, 105, 105a, 107, 107a) including at least two main layers (100b) of indium and gallium nitride, separated two by two at least by an intermediate layer (100a) of gallium nitride, at least one of the main layers (100b) being doped according to a first type of doping selected among an N-type doping and a P-type doping; and
- at least one active layer (104, 104a, 104b, 106, 106a, 108) totally or partially formed over all or part of the stack, the active layer including at least one quantum well;
wherein each sub-pixel comprises at least one first of the layer sets, the first layer set being formed over all or part of the support surface (110), the two main layers (100b) of the stack of the first layer set meeting the formula InzGa1-zN where 0≤z<0.1;
and wherein:
a first sub-pixel (113) of the sub-pixels of the pixel comprises a first junction layer (109e) doped according to a second type of doping, formed over and in contact with the active layer (104b) of the first layer set of the first sub-pixel, such that the active layer (104b) of the first layer set of the first sub-pixel is adapted to emit a light radiation substantially having a first wavelength, the second type of doping being selected among N-type doping and P-type doping, where the second type of doping is different from the first type of doping;
a second sub-pixel (112) of the sub-pixels of the pixel comprises a second layer set among the layer sets, formed over the first layer set of the second sub-pixel, the two main layers (100b) of the stack (105a) of the second layer set meeting the formula InxGa1-xN where 0.1≤x<0.2; and
the second sub-pixel (112) comprises a second junction layer (109d) formed over and in contact with the active layer (106a) of the second layer set, the second junction layer (109d) being doped according to the second type of doping such that the active layer (106a) of the second layer set is adapted to emit a light radiation substantially having a second wavelength distinct from the first wavelength.

2. The optoelectronic device (10) according to claim 1, **characterized in that** the second sub-pixel (112) comprises:
a third junction layer (109c) totally or partially formed over all or part of the active layer (104a) of the first layer set of the second sub-pixel and doped according to said second type of doping, and
a first tunnel junction (121a) formed between all or part of the stack (105a) of the second layer set and all or part of the third junction layer (109c).

3. The optoelectronic device (10) according to claim 1 or 2, **characterized in that** each sub-pixel (111, 112, 113) comprises at least one semiconductor buffer layer (102, 102a, 102b) formed over the support surface (110) of the substrate (101) and over which all or part of the first layer set is formed.

4. The optoelectronic device (10) according to any of claims 1 to 3, **characterized in that** the second wavelength of the light radiation adapted to be emitted by the active layer (106a) of the second layer set of the second sub-pixel (112) is comprised between 500 and 580 nm so that the light radiation adapted to be emitted by the second sub-pixel is substantially green-colored.

5. The optoelectronic device (10) according to any of claims 1 to 4, **characterized in that** the second layer set of the second sub-pixel (112) comprises:
first electrical contacts (131b, 131ii) electrically connected with the second junction layer (109d) of the second sub-pixel, and
second electrical contacts (131c, 132i) electrically connected with the stack (105a) of the second layer set of the second sub-pixel.

6. The optoelectronic device (10) according to any of claims 1 to 5, **characterized in that**:
the active layer (104) of each first layer set comprises a proportion of Indium higher than the proportion of Indium in the stack (103) of the first layer set, and/or
the active layer (106) of each second layer set comprises a proportion of Indium higher than the proportion of Indium in the stack (105) of the second layer set.

7. The optoelectronic device (10) according to any of claims 1 to 6, **characterized in that** the pixel comprises a third sub-pixel (111) comprising a light-emitting diode adapted to emit a third light radiation, and the third sub-pixel comprising:
a second of the layer sets, formed over the first layer set of the third sub-pixel, the main layers (100b) of the stack (105) of the second layer set meeting the formula InxGa1-xN where 0.1≤x<0.2; and
a third of the layer sets, totally or partially formed over all or part of the active layer (106) of the second layer set of the third sub-pixel, the main layers (100b) of the stack (107) of the third layer set meeting the formula InyGa1-yN where 0.2≤y≤0.35, the third sub-pixel comprising a fourth junction layer (109b) formed over and in contact with the active layer (108) of the third layer set, the fourth junction layer (109b) of the third sub-pixel being doped according to the second type of doping, such that the active layer (108) of the third layer set is adapted to emit light radiation substantially having a third wavelength.

8. The optoelectronic device (10) according to claim 7, **characterized in that** the third sub-pixel (111) comprises:
- a fifth junction layer (109a) totally or partially formed over all or part of the active layer (106) of the second layer set of the third sub-pixel and doped according to said second type of doping, and
- a tunnel junction (122) formed between all or part of the stack (107) of the third layer set of the third sub-pixel and all or part of the fifth junction layer (109a) of the third sub-pixel.

9. The optoelectronic device (10) according to any of claims 7 or 8, **characterized in that** the active layer (108) of the third layer set comprises a proportion of Indium higher than the proportion of Indium in the stack (107) of the third layer set.

10. The optoelectronic device (10) according to any of claims 7 to 9, **characterized in that** the third wavelength is comprised between 590 and 680 nm so that the light radiation adapted to be emitted by the third sub-pixel (111) is substantially red-colored.

11. The optoelectronic device (10) according to any of claims 7 to 10, **characterized in that** the third sub-pixel (111) comprises first electrical contacts (131, 131i) electrically connected with the fourth junction layer (109b) of the third layer set and second electrical contacts (131a, 132) electrically connected with the stack (107) of the third layer set.

12. The optoelectronic device (10) according to any of claims 1 to 11, **characterized in that** the first sub-pixel (113) comprises:
- at least one stack (105b) totally or partially formed over all or part of the first junction layer (109e) of the first sub-pixel and including at least two main layers (100b) of indium and gallium nitride meeting the formula InxGa1-xN where 0.1≤x<0.2 separated two by two at least by an intermediate layer (100a) of gallium nitride, at least one of the main layers (100b) of the first sub-pixel being doped according to said first type of doping; and
- a tunnel junction (121b) formed between all or part of the stack (105b) and all or part of the first junction layer (109e) of the first sub-pixel.

13. The optoelectronic device (10) according to any of claims 1 to 12, **characterized in that** the first wavelength is comprised between 400 and 490 nm so that the light radiation adapted to be emitted by the first sub-pixel is substantially blue-colored.

14. The optoelectronic device (10) according to any of claims 12 to 13, **characterized in that** the first sub-pixel (113) comprises first electrical contacts (131d, 131 iii) electrically connected with the first junction layer (109e) of the first sub-pixel and the second electrical contacts (131e, 132i) electrically connected with the stack (103b) of the first layer set of the first sub-pixel.

15. The optoelectronic device (10) according to any of claims 1 to 14, **characterized in that** the sub-pixels (111, 112, 113) are electrically insulated from each other via an insulating trench (14) directed transversely relative to the general plane directed parallel to the plane of the support face (110) of the substrate (101).

16. A method for manufacturing an optoelectronic device (10), including a phase of forming at least two sub-pixels (111, 112, 113) of a pixel, the method including the following steps:
a) forming a substrate (101) having a support surface (110);
b) forming several layer sets including a first layer set for each sub-pixel, the first layer set being formed over all or part of the support face (110), each layer set comprising:
a stack (103, 103a, 103b, 105, 105a, 107, 107a) including at least two first main layers (100b) of indium and gallium nitride, separated two by two at least by a first intermediate layer (100a) of gallium nitride, at least one of the first main layers (100b) being doped according to a first type of doping selected from an N-type doping and a P-type doping, the first main layers (100b) of the first layer set of each sub-pixel meeting the formula InzGa1-zN where 0≤z<0.1; and
at least one active layer (104, 104a, 104b, 106, 106a, 108) totally or partially formed over all or part of the stack, the active layer including at least one quantum well;
c) forming, over all or part of the active layer (104b) of the first layer set of at least one first sub-pixel (113) of the sub-pixels, a first junction layer (109e) doped according to a second type of doping, formed over and in contact with the active layer (104b) of the first layer set of the first sub-pixel, such that the active layer (104b) of the first layer set of the first sub-pixel is adapted to emit a light radiation substantially having a first wavelength, the second type of doping being selected among N-type doping and P-type doping, where the second type of doping is different from the first type of doping;
d) forming, over all or part of the active layer (104a) of the first layer set of at least one second sub-pixel (112) of the sub-pixels, a second of the layer sets, the main layers (100b) of the stack (105a) of the second layer set meeting the formula InxGa1-xN where 0.1≤x<0.2; and
e) forming all or part of a second junction layer (109d) over and in contact with the active layer (106a) of the second layer set of the second sub-pixel and doped according to the second type of doping, such that the active layer (106a) of the second layer set is adapted to emit light radiation substantially having a second wavelength distinct from the first wavelength.

17. The manufacturing method according to claim 16, comprising a step of forming a semiconductor buffer layer (102, 102a, 102b) over the support face (110) of the substrate (101), all or part of the first layer set being formed over all or part of the buffer layer.

18. The manufacturing method according to any of claims 16 or 17, comprising a step of forming all or part of a third junction layer (109c) doped according to said second type of doping on all or part of the active layer (104a) of the first layer set of the second sub-pixel (112), and of a first tunnel junction (121a) between all or part of the stack (105a) of the second layer set and all or part of the third junction layer (109c), of the second sub-pixel.

19. The manufacturing method according to any of claims 16 to 18, comprising a step of forming first electrical contacts (131b, 131 ii) electrically connected with the second junction layer (109d) and second electrical contacts (131c, 132i) electrically connected with the stack (105a) of the second layer set of the second sub-pixel (112).

20. The method for manufacturing an optoelectronic device (10) according to any of claims 16 to 19, comprising the formation of at least one third of the sub-pixels (111) of the pixel comprising the steps of:
forming a second of the layer sets on all or part of the active layer (104) of the first layer set of the third sub-pixel, the main layers (100b) of the second layer set meeting the formula InxGa1-xN where 0.1≤x<0.2;
forming a third of the layer sets on all or part of the active layer (106) of the second layer set of the third sub-pixel, the main layers (100b) of the third layer set meeting the formula InyGa1-yN where 0.2≤y≤0.35; and
forming all or part of at least one third junction layer (109b) over and in contact with the active layer (108) of the third layer set, the third junction layer (109b) being doped according to the second type of doping, such that the active layer (108) of the third layer set is adapted to emit a light radiation substantially having a third wavelength.

21. The manufacturing method according to claim 20, **characterized in that** the formation of the third sub-pixel (111) of the pixel comprises steps of:
forming all or part of at least one fourth junction layer (109) on all or part of the active layer (104) of the first layer set of the third sub-pixel, the fourth junction layer (109) being doped according to said second type of doping;
forming all or part of a first tunnel junction (121) between all or part of the stack (105) of the second layer set of the third sub-pixel and all or part of the fourth junction layer (109); and
forming all or part of at least one fifth junction layer (109a) doped according to said second type of doping over all or part of the active layer (106) of the second layer set of the third sub-pixel and of a second tunnel junction (122) between all or part of the stack (107) of the third layer set and all or part of the fifth junction layer (109a).

22. The manufacturing method according to any of claims 20 and 21, **characterized in that** the formation of the third sub-pixel (111) of the pixel comprises a step of forming first electrical contacts (131, 131i) electrically connected with the third junction layer (109b) and second electrical contacts (131a, 132) electrically connected with the stack (107) of the third layer set of the third sub-pixel.

23. The manufacturing method according to any of claims 16 to 22, wherein the formation of the first sub-pixel (113) comprises the steps of forming at least one first junction layer (109e) doped according to the second type of doping, over and in contact with the active layer (104b) of the first layer set of the first sub-pixel.

24. The manufacturing method according to claim 23, **characterized in that** the formation of the first sub-pixel (113) comprises the following steps of:
form ing at least one second stack (105b) totally or partially over all or part of the sixth junction layer (109e) of the first sub-pixel and including at least two second main layers of indium and gallium nitride meeting the formula InxGa1-xN where 0.1≤x<0.2 separated two by two at least by one second intermediate layer of gallium nitride, at least one of the second main layers being doped according to said first type of doping; and
forming a tunnel junction (121b) between all or part of the second stack (105b) and all or part of the sixth junction layer (109e) of the first sub-pixel.

25. The manufacturing method according to any of claims 23 and 24, **characterized in that** the phase of forming the first sub-pixel (113) comprises a step of forming electrical contacts (131d, 131ii) electrically connected with the sixth layer junction (109e) of the first sub-pixel, and second electrical contacts (131e, 132i) electrically connected with the stack (103b) of the first layer set of the first sub-pixel.

26. The manufacturing method according to any of claims 22 to 25, **characterized in that** the first layer sets of the first, second and third sub-pixels (111, 112, 113) are formed at the same time and with the same technique, and **in that** the second layer sets of the second and third sub-pixels (111, 112) are formed at the same time and with the same technique.

27. The manufacturing method according to any of claims 21 to 26, wherein at least one of the following conditions is verified:
- the stacks (103, 103a, 103b) of the first layer set of two distinct sub-pixels are formed at the same time and with the same technique,
- the stacks (105, 105a, 105b) of the second layer set of two distinct sub-pixels are formed at the same time and with the same technique,
- the active layers (104, 104a, 104b) of the first layer set of two distinct sub-pixels are formed at the same time and with the same technique,
- the active layers (106, 106a) of the second layer set of two distinct sub-pixels are formed at the same time and with the same technique,
- the stacks (107a, 107) of the third layer set of two distinct sub-pixels are formed at the same time and with the same technique,
- the tunnel junctions (121, 121a, 121b) of two distinct sub-pixels are partially formed at the same time and with the same technique.
